# EUROPEAN PATENT SPECIFICATION

(11) **EP 2 204 875 B1**
(45) Date of publication and mention of the grant of the patent: **28.09.2011**
(21) Application number: 10001438.0
(22) Date of filing: 27.05.2004
(51) Int. Cl.: H01M 14/00, H01B 1/06, H01L 31/04

(54) **Electrolyte composition and photoelectric conversion element using same**
Elektrolytzusammensetzung und photoelektrisches Umwandlungselement unter Verwendung der Zusammensetzung
Composition d'électrolyte et élément de conversion photoélectrique l'utilisant

(30) Priority: 30.05.2003 JP 2003156019; 30.05.2003 JP 2003156020; 30.05.2003 JP 2003156021
(43) Date of publication of application: 07.07.2010
(62) Divisional of application: 04745532.4
(73) Proprietor: Fujikura, Ltd., Tokyo 135-0042 (JP)
(72) Inventor: Watanabe, Masayoshi, Hodogaya-ku Yokohama-shi Kanagawa-ken (JP); Kawano, Ryuji, Hodogaya-ku Yokohama-shi Kanagawa-ken (JP); Matsui, Hiroshi, Kohtoh-ku Tokyo (JP); Tanabe, Nobuo, Kohtoh-ku Tokyo (JP)
(74) Representative: Weitzel, Wolfgang

(56) References cited:
- WO-A1-93/20569
- JP-A- 1 074 712
- US-A- 4 488 943

## Description

### TECHNICAL FIELD

The present invention relates to an electrolyte composition used in a photoelectric conversion element such as a dye-sensitized solar cell, as well as a photoelectric conversion element using such a composition.

Priority is claimed on Japanese Patent Application No. 2003-156019, filed May 30, 2003, Japanese Patent Application No. 2003-156020, filed May 30, 2003, and Japanese Patent Application No. 2003-156021, filed May 30, 2003.

### BACKGROUND ART

As has been disclosed in Japanese Patent No. 2,664,194, Japanese Unexamined Patent Application, First Publication No. 2001-160427, and by M. Graetzel et al. in Nature, (UK) 737 (1991) p. 353, dye-sensitized solar cells, which were developed by Graetzel et al. in Switzerland, offer the advantages of a high level of photoelectric conversion efficiency, and low production costs, and are consequently attracting considerable attention as a potential new type of solar cell.

The general structure of a dye-sensitized solar cell includes a working electrode, including a porous film, containing fine particles (nanoparticles) of an oxide semiconductor such as titanium dioxide with a photosensitizing dye supported thereon, formed on top of a transparent, conductive electrode substrate, and a counter electrode disposed opposing this working electrode, and the space between the working electrode and the counter electrode is filled with an electrolyte containing a redox pair.

In this type of dye-sensitized solar cell, the photosensitizing dye absorbs an incident light such as sunlight, causing a sensitization of the fine particles of the oxide semiconductor, and generating an electromotive force between the working electrode and the counter electrode. Accordingly, the dye-sensitized solar cell functions as a photoelectric conversion element that converts light energy into electric power.

The electrolyte typically uses an electrolyte solution containing a redox pair such as I⁻/I₃⁻ dissolved in an organic solvent such as acetonitrile. Other electrolytes include nonvolatile ionic liquids, and solidified electrolytes including a liquid electrolyte (an electrolyte solution) that has been converted to a gel using a suitable gelling agent, and dye-sensitized solar cells that use a solid semiconductor such as a p-type semiconductor are also known.

However, in those cases where an organic solvent such as acetonitrile is used in the preparation of the electrolyte, there is a danger that if the quantity of the electrolyte decreases due to volatilization of the organic solvent, the conductivity between the electrodes will deteriorate, resulting in a reduction in the photoelectric conversion characteristics. As a result, it is difficult for the photoelectric conversion element to ensure a satisfactory long-term stability.

In those cases where a nonvolatile ionic liquid is used as the electrolyte, although problems of volatilization of the electrolyte can be avoided, there is a danger of liquid leakage during production, or if the cell is damaged, which is unsatisfactory in terms of handling (ease of handling).

In those cases where either a solidified electrolyte including a liquid electrolyte (an electrolyte solution) that has been converted to a gel, or a solid semiconductor such as a p-type semiconductor is used, handling (the ease of handling) improves. However, with current configurations the photoelectric conversion characteristics and the stability of the cell output are inferior, and improvement is required.

### DISCLOSURE OF INVENTION

An object of the present invention is to provide a photoelectric conversion element which is able to avoid volatilization or leakage of the electrode, and offers improved photoelectric conversion characteristics and output stability, as well as an electrolyte composition that is suitable for use in such a photoelectric conversion element.

An electrolyte composition according to a first aspect not according to the present invention is a solid electrolyte, which includes a polymer compound containing a cation structure selected from a group consisting of ammonium, phosphonium and sulfonium structures in either the principal chain or a side chain of the polymer, and a halide ion and/or a polyhalide as the counter anion.

According to this aspect, because the composition is in a solid state, volatility and fluidity are poor, meaning deterioration or loss of the electrolyte through solvent volatilization or the like does not occur. By using this type of electrolyte composition as the electrolyte for a photoelectric conversion element, a high output level and favorable photoelectric conversion characteristics can be achieved with good stability. Furthermore, leakage of the electrolyte through gaps in the container, or scattering of the electrolyte caused by damage to the element can also be suppressed, resulting in excellent handling properties.

The above polymer compound may include both a halide ion and a polyhalide as the counter anion, and this halide ion and polyhalide may form a redox pair. Such cases result in particularly desirable characteristics when the composition is used as the electrolyte for a photoelectric conversion element.

The halide ion or polyhalide described above may be an iodine based anion.

The redox pair formed from the halide ion and the polyhalide may be I⁻/I⁻.

A photoelectric conversion element according to this first aspect includes an electrolyte composition of the first aspect of the present invention as the electrolyte.

According to this aspect, a high output level and favorable photoelectric conversion characteristics can be achieved with good stability. Furthermore, leakage of the electrolyte through gaps in the container, or scattering of the electrolyte caused by damage to the element can also be suppressed, resulting in excellent handling properties.

A photoelectric conversion element according to this first aspect may be a dye-sensitized solar cell, including a working electrode, which includes an oxide semiconductor porous film with a dye supported thereon formed on an electrode substrate, and a counter electrode disposed opposing this working electrode, wherein an electrolyte layer formed from an electrolyte composition according to the first aspect of the present invention is provided between the working electrode and the counter electrode.

An electrolyte composition according to a second aspect which is according to the present invention is a solid electrolyte, which includes a polymer compound containing a cation structure formed by partial oxidation of a π-conjugated polymer as the principal chain of the polymer, and a halide ion and/or a polyhalide as the counter anion.

According to this aspect of the present invention, because the composition is in a solid state, volatility and fluidity are poor, meaning deterioration or loss of the electrolyte through solvent volatilization or the like does not occur. By using this type of electrolyte composition as the electrolyte for a photoelectric conversion element, a high output level and favorable photoelectric conversion characteristics can be achieved, and the element is able to function with good stability over extended periods. Furthermore, leakage of the electrolyte through gaps in the container, or scattering of the electrolyte caused by damage to the element can also be suppressed, resulting in excellent handling properties.

The above polymer compound may include both a halide ion and a polyhalide as the counter anion, and this halide ion and polyhalide may form a redox pair. Such cases result in particularly desirable characteristics when the composition is used as the electrolyte for a photoelectric conversion element.

The halide ion or polyhalide described above may be an iodine based anion.

The redox pair formed from the halide ion and the polyhalide may be I⁻/I₃⁻.

A photoelectric conversion element according to this second aspect of the present invention includes an electrolyte composition of the second aspect of the present invention as the electrolyte.

According to this aspect of the present invention, a high output level and favorable photoelectric conversion characteristics can be achieved with good stability. Furthermore, leakage of the electrolyte through gaps in the container, or scattering of the electrolyte caused by damage to the element can also be suppressed, resulting in excellent handling properties.

A photoelectric conversion element according to this second aspect of the present invention may be a dye-sensitized solar cell, including a working electrode, which includes an oxide semiconductor porous film with a dye supported thereon formed on an electrode substrate, and a counter electrode disposed opposing this working electrode, wherein an electrolyte layer formed from an electrolyte composition according to the second aspect of the present invention is provided between the working electrode and the counter electrode.

An electrolyte composition according to a third aspect not according to the present invention is a solid electrolyte, which includes a polymer compound containing a cation structure, generated by the action of a halogen atom on a polymer with a partial π-conjugated structure, in either the principal chain or a side chain of the polymer, and a halide ion and/or a polyhalide as the counter anion to this cation structure.

According to this aspect, because the composition is in a solid state, volatility and fluidity are poor, meaning deterioration or loss of the electrolyte through solvent volatilization or the like does not occur. By using this type of electrolyte composition as the electrolyte for a photoelectric conversion element, a high output level and favorable photoelectric conversion characteristics can be achieved by the photoelectric conversion element, and the element can function with good stability over extended periods. Furthermore, leakage of the electrolyte through gaps in the container, or scattering of the electrolyte caused by damage to the element can also be suppressed, resulting in excellent handling properties.

The above polymer compound may include both a halide ion and a polyhalide as the counter anion, and this halide ion and polyhalide may form a redox pair. Such cases result in particularly desirable characteristics when the composition is used as the electrolyte for a photoelectric conversion element.

The halide ion or polyhalide described above may be an iodine based anion.

The redox pair formed from the halide ion and the polyhalide may be I⁻/I₃⁻.

A photoelectric conversion element according to this third aspect of the present invention includes an electrolyte composition of the third aspect of the present invention as the electrolyte.

According to this aspect, a high output level and favorable photoelectric conversion characteristics can be achieved with good stability. Furthermore, leakage of the electrolyte through gaps in the container, or scattering of the electrolyte caused by damage to the element can also be suppressed, resulting in excellent handling properties.

A photoelectric conversion element according to this third aspect may be a dye-sensitized solar cell, including a working electrode, which includes an oxide semiconductor porous film with a dye supported thereon formed on an electrode substrate, and a counter electrode disposed opposing this working electrode, wherein an electrolyte layer formed from an electrolyte composition according to the third aspect of the present invention is provided between the working electrode and the counter electrode.

### BRIEF DESCRIPTION OF DRAWINGS

FIG. 1 is a schematic cross sectional view showing a dye-sensitized solar cell representing an embodiment of a photoelectric conversion element according to the present invention.
FIG. 2A is a top view showing the glass plate used for testing the state of an electrolyte composition.
FIG. 2B is a side view showing a glass plate with an electrolyte film formed thereon, positioned in an upright state.
FIG. 3 is a graph showing the measurement results for current vs. voltage curves for photoelectric conversion elements (test cells) from examples (not according to the present invention).

### BEST MODE FOR CARRYING OUT THE INVENTION

As follows is a description of preferred embodiments of the present invention, with reference to the drawings. The present invention is in no way restricted to the embodiments described below, and for example, suitable combinations of structural elements from the different embodiments are also possible.

The present invention is described below in detail, based on the embodiments.

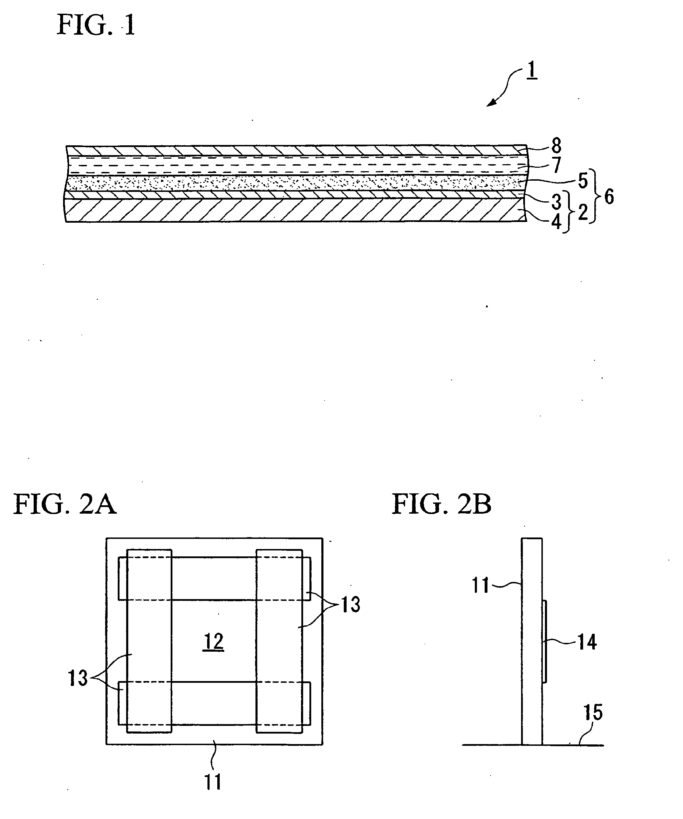

FIG. 1 is a schematic cross sectional view showing a dye-sensitized solar cell that represents an embodiment of a photoelectric conversion element according to the present invention.

This dye-sensitized solar cell 1 includes a working electrode 6, including an oxide semiconductor porous film 5, formed from fine particles of an oxide semiconductor such as titanium oxide with a photosensitizing dye supported thereon, provided on top of a transparent electrode substrate 2, and a counter electrode 8 provided opposing this working electrode 6. An electrolyte layer 7 is formed between the working electrode 6 and the counter electrode 8.

An electrolyte composition and a photoelectric conversion element according to the first aspect are described with reference to the dye-sensitized solar cell of the embodiment shown in FIG. 1.

The electrolyte composition that forms the electrolyte layer 7 includes, as an essential component, a polymer compound containing a cation structure selected from a group consisting of ammonium, phosphonium and sulfonium structures on either the principal chain or a side chain of the polymer, and a halide ion and/or a polyhalide as the counter anion.

The polymer compound may be either a single polymer compound, or a mixture of a plurality of different polymer compounds. The molecular weight for the polymer compound is within a range from several hundred to several million, and preferably from several thousand to several hundred thousand, and even more preferably in the order of several tens of thousands.

The polymer compound contains at least one of either a single cation structure or a plurality of different cation structures, selected from those described below.

Ammonium structures and phosphonium structures refer to structures represented by either of the formulas (1-1) and (1-2) shown below. In these formulas (1-1) and (1-2), the cation center E represents either a nitrogen (N) atom or a phosphorus (P) atom.

In the formula (1-1), R^{a}, R^{b}, R^{c} and R^{d} each represent an arbitrary adjacent atom for forming a hydrogen atom, an alkyl group, an aryl group, an alkoxy group, an alkylamino group or an alkenyl group or the like. Two or more of R^{a}, R^{b}, R^{c} and R^{d} may also represent a group of atoms that forms a heterocyclic ring incorporating the cation center E.

In the formula (1-2), R^{e} represents an arbitrary adjacent atom for forming an alkylidene group, an alkylimino group or an alkenylidene group or the like. Furthermore, R^{f} and R^{g} each represent an arbitrary adjacent atom for forming a hydrogen atom, an alkyl group, an aryl group, an alkoxy group, an alkylamino group or an alkenyl group or the like. Two or more of R^{e}, R^{f} and R^{g} may also represent a group of atoms that forms a heterocyclic ring incorporating the cation center E.

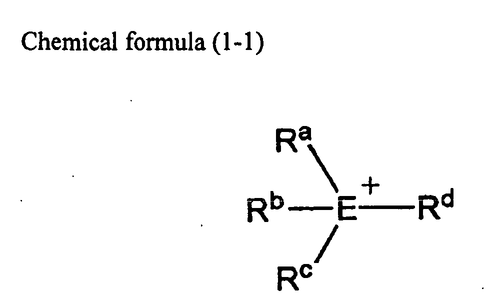

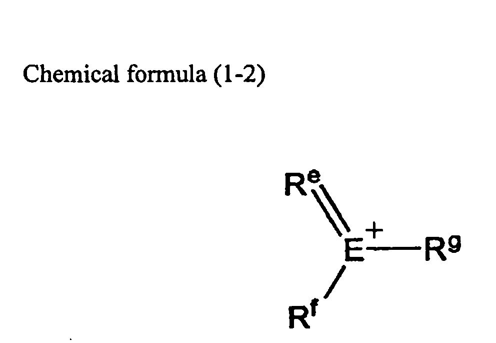

Sulfonium structures refer to structures represented by the formulas (1-3) or (1-4) shown below. In these formulas (1-3) and (1-4), the cation center E represents a sulfur (S) atom.

In the formula (1-3), R^{h}, Rⁱ and Rⁱ each represent an arbitrary adjacent atom for forming a hydrogen atom, an alkyl group, an aryl group, an alkoxy group, an alkylamino group or an alkenyl group or the like. Two or more of R^{h}, Rⁱ and R^{j} may also represent a group of atoms that forms a heterocyclic ring incorporating the cation center E.

In the formula (1-4), R^{k} represents an arbitrary adjacent atom for forming an alkylidene group, an alkylimino group or an alkenylidene group or the like. Furthermore, R¹ represents an arbitrary adjacent atom for forming a hydrogen atom, an alkyl group, an aryl group, an alkoxy group, an alkylamino group or an alkenyl group or the like. R^{k} and R¹ may also represent a group of atoms that forms a heterocyclic ring incorporating the cation center E.

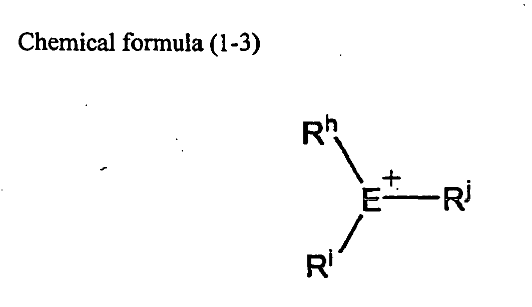

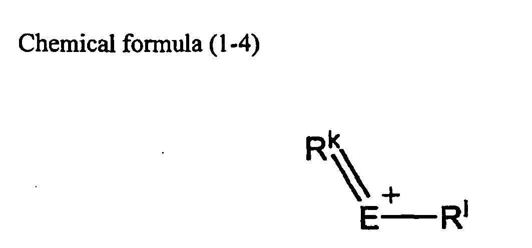

The ammonium structure may be a structure in which the cationic nitrogen atom is not incorporated within a cyclic structure (such as a tetraalkylammonium structure), or a structure in which the cationic nitrogen atom is incorporated within a cyclic structure, and examples of such cyclic structures (heterocycles) include a variety of structures such as imidazolium structures (imidazole derivatives), pyridinium structures (pyridine derivatives), diazolium structures (diazole derivatives), triazolium structures (triazole derivatives), quinolinium structures (quinoline derivatives), triazinium structures (triazine derivatives), aziridinium structures (aziridine derivatives), pyrazolium structures (pyrazole derivatives), pyrazinium structures (pyrazine derivatives), acridinium structures (acridine derivatives), indolium structures (indole derivatives), bipyridinium structures (bipyridine derivatives) and terpyridinium structures (terpyridine derivatives).

The aforementioned polymer compound may also include non-cationic nitrogen atoms (such as amines), phosphorus atoms (such as phosphines), and sulfur atoms (such as sulfides) in addition to the cation structure. The ratio of the cationic N, P or S atoms relative to the total number of N, P or S atoms is preferably at least 1% (and may be 100%).

Polymer compounds in which the principal chain is a poly(methylene) chain, a poly(ethylene oxide) chain, a fluorocarbon chain, or a polymer chain with conjugated unsaturated bonds such as a polyene, a polyarylene or a polyyne, and the side chain or chains include at least one of an ammonium structure, a phosphonium structure and a sulfonium structure can be used as the aforementioned polymer compound.

Specific examples of these types of polymer compounds, containing a cationic structure on a side chain, include the polymer compounds represented by the formulas (1-5) and (1-6) shown below. In all following chemical formulas within this description, a wavy line enclosed within brackets and labeled with a subscript n is used as an abbreviation for the principal chain of the polymer compound.

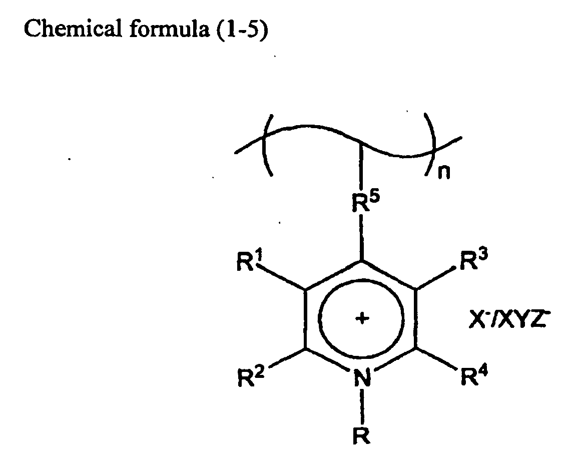

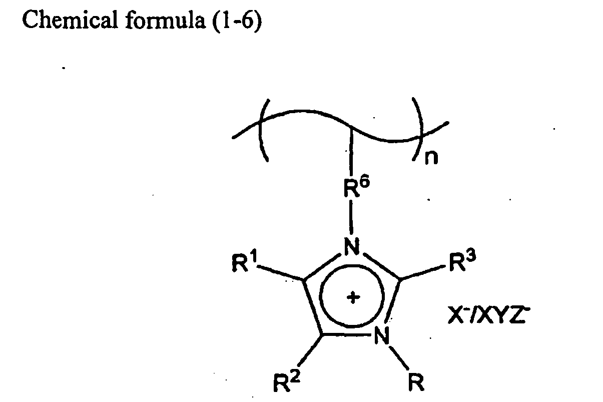

In the formulas (1-5) and (1-6), the substituent R represents a hydrogen atom; a straight chain alkyl group such as a methyl, ethyl, propyl, n-butyl, n-pentyl, n-hexyl or n-octyl group; a branched alkyl group such as an isopropyl, isobutyl, sec-butyl, tert-butyl, isopentyl or neopentyl group; a straight chain or branched alkoxy group such as a methoxy, ethoxy, propoxy, isopropoxy, butoxy, isobutoxy, sec-butoxy or tert-butoxy group; an alkenyl group such as a vinyl, propenyl, allyl, butenyl or oleyl group; an alkynyl group such as an ethynyl, propynyl or butynyl group; an alkoxyalkyl group such as a methoxymethyl, 2-methoxyethyl, 2-ethoxyethyl or 3-ethoxypropyl group; a polyether group such as a C₂H₅O(CH₂CH₂O)ₘCH₂CH₂ group (wherein m is an integer of at least 1) or a CH₃O(CH₂CH₂O)ₘCH₂CH₂ group (wherein m is an integer of at least 1); or a derivative of one of these groups substituted with a halogen such as fluorine, such as a fluoromethyl group.

The groups R¹, R², R³ and R⁴ can be selected independently, with each group representing a hydrogen atom; a straight chain alkyl group such as a methyl, ethyl, propyl, butyl (n-butyl), pentyl (n-pentyl), hexyl, octyl, dodecyl, hexadecyl or octadecyl group; a branched alkyl group such as an isopropyl, isobutyl, sec-butyl, tert-butyl, isopentyl or neopentyl group; a straight chain or branched alkoxy group such as a methoxy, ethoxy, propoxy, isopropoxy, butoxy, isobutoxy, sec-butoxy or tert-butoxy group; an alkenyl group such as a vinyl, propenyl, allyl, butenyl or oleyl group; an alkynyl group such as an ethynyl, propynyl or butynyl group; an alkoxyalkyl group such as a methoxymethyl, 2-methoxyethyl, 2-ethoxyethyl or 3-ethoxypropyl group; a polyether group such as a C₂H₅O(CH₂CH₂O)ₘCH₂CH₂ group (wherein m is an integer of at least 1) or a CH₃O(CH₂CH₂O)ₘCH₂CH₂ group (wherein m is an integer of at least 1); or a derivative of one of these groups substituted with a halogen such as fluorine, such as a fluoromethyl group.

Examples of the bivalent groups R⁵ and R⁶ include a direct bond between the polymer principal chain and the heterocyclic ring, a straight chain or branched alkylene group such as a methylene, ethylene, propylene, trimethylene or tetramethylene group; an alkenylene group such as a vinylene, methylvinylene or propenylene group; an alkynylene group such as an ethynylene group; a bivalent group with an ether linkage such as an alkyleneoxyalkylene group; or a polyether group.

Examples of possible counter anions for the cationic structure within the polymer compound include halide ions (recorded as X⁻ in the chemical formulas) such as iodide ions, bromide ions and chloride ions; and polyhalide ions (recorded as XYZ⁻ in the chemical formulas) such as Br3⁻, I₃⁻, I₅⁻, I₇⁻, Cl₂I⁻, ClI₂⁻, Br₂I⁻ and BrI₂⁻. Polyhalide ions are anions including a plurality of halogen atoms, and can be obtained by reacting a halide ion such as Cl⁻, Br⁻ or I⁻ with a halogen molecule. This halogen molecule can use either simple halogen molecules such as Cl₂, Br₂ and I₂, and/or interhalogen compounds such as ClI, BrI and BrCl.

There are no particular restrictions on the ratio of the halogen molecules to the halide ions, and molar ratios from 0% to 100% are preferred. Although addition of halogen molecules is not essential, such halogen molecule addition is preferred. In those cases where halogen molecules are added to form polyhalide ions, the halide ion and the polyhalide ion form a redox pair, enabling an improvement in the photoelectric conversion characteristics.

The polymer compounds represented by the above formulas (1-5) and (1-6) can be produced using known synthesis techniques. For example, a tertiary amine precursor such as those shown below in the formulas (1-7) and (1-8) is reacted with an alkyl halide such as an alkyl iodide (RI), thus generating a quaternary nitrogen atom. The group R within the alkyl halide represents the same types of groups as the group R within the above formulas (1-5) and (1-6). The ratio (the quaternization ratio) of quaternary ammonium structures relative to the total number of nitrogen atoms within the polymer compound (the sum total of tertiary amine structures and quaternary ammonium structures) is preferably at least 1%, and can be as high as 100%.

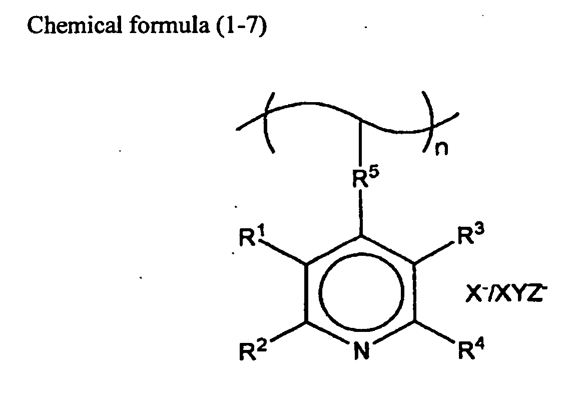

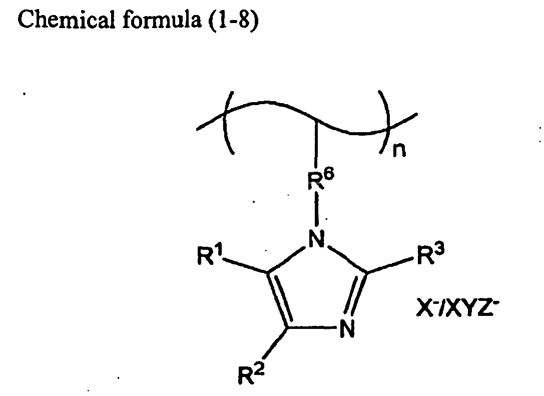

As follows is a description of specific examples of preferred polymer compounds.
(a) Polymer compounds with a tertiary ammonium structure: examples include poly(ethyleneimine) hydrochloride, poly(4-vinylpyridinium chloride) and poly(2-vinylpyridinium chloride).
(b) Polymer compounds with an aliphatic quaternary ammonium structure: examples include poly(vinyltrialkylammonium chlorides) such as poly(vinyltrimethylammonium chloride), poly(allyltrialkylammonium chlorides) such as poly(allyltrimethylammonium chloride), and poly(oxyethyl-1-methylenetrialkylammonium chlorides) such as poly(oxyethyl-1-methylenetrimethylammonium chloride).
(c) Polymer compounds with a quaternary ammonium structure substituted with an aromatic hydrocarbon group: examples include poly(benzyltrialkylammonium chlorides) such as poly(benzyltrimethylammonium chloride).
(d) Polymer compounds with a quaternary ammonium structure incorporated within a heterocyclic structure: examples include poly(N-alkyl-2-vinylpyridinium chlorides) such as poly(N-methyl-2-vinylpyridinium chloride), poly(N-alkyl-4-vinylpyridinium chlorides) such as poly(N-methyl-4-vinylpyridinium chloride), poly(N-vinyl-2,3-dialkylimidazolium chlorides) such as poly(N-vinyl-2,3-dimethylimidazolium chloride), poly(N-alkyl-2-vinylimidazolium chlorides) such as poly(N-methyl-2-vinylimidazolium chloride), and poly(oxyethyl-1-methylenepyridinium chloride).
(e) Acrylic polymer compounds with an ammonium structure: examples include poly(2-hydroxy-3-methacryloyloxypropyltrialkylammonium chlorides) such as poly(2-hydroxy-3-methacryloyloxypropyltrimethylammonium chloride), and poly(3-acrylamidepropyltrialkylammonium chlorides) such as poly(3-acrylamidepropyltrimethylammonium chloride).
(f) Polymer compounds with a sulfonium structure: examples include poly(2-acryloyloxyethyldialkylsulfonium chlorides) such as poly(2-acryloyloxyethyldimethylsulfonium chloride), and poly(glycidyldialkylsulfonium chlorides) such as poly(glycidyldimethylsulfonium chloride).
(g) Polymer compounds with a phosphonium structure: examples include poly(glycidyltrialkylphoshonium chlorides) such as poly(glycidyltributylphoshonium chloride).

Furthermore, chlorides were presented in the specific examples above, but the polymer compounds capable of being used are not restricted to chlorides, and other halide or polyhalide salts such as bromides, iodides, tribromides (Br3⁻ salts) and triiodides (I₃⁻ salts) can also be used.

Furthermore, the cationic polymer can also use a polymer compound with at least one ammonium structure, phosphonium structure or sulfonium structure within the principal chain. Examples of structural units that can be incorporated within the principal chain and contain an ammonium structure include pyridinium, piperidinium, piperazinium and aliphatic ammonium structures. Examples of other structural units that can be incorporated within the principal chain include methylene, ethylene, vinylene and phenylene units, and ether linkages. A specific example of this type of cationic polymer is poly(N,N-dimethyl-3,5-methylenepiperidinium chloride).

In conventional gel-like electrolyte compositions where a liquid electrolyte is gelled and solidified, the polymer performs the role of the curing agent for curing the liquid electrolyte.

In contrast, in an electrolyte composition, the polymer compound described above displays conductivity itself, performs an important role in charge transfer in an electrolyte composition containing a redox pair, and is a solid.

A variety of additives such as ionic liquids; organic nitrogen compounds such as 4-tert-butylpyridine, 2-vinylpyridine and N-vinyl-2-pyrrolidone; and other additives such as lithium salts, sodium salts, magnesium salts, iodide salts, thiocyanates and water can be added to the electrolyte composition of the present invention if required, provided such addition does not impair the properties and characteristics of the electrolyte composition. Examples of the aforementioned ionic liquids include salts that are liquid at room temperature, and include a cation such as a quaternary imidazolium, quaternary pyridinium or quaternary ammonium ion, and an anion such as an iodide ion, a bis-trifluoromethylsulfonylimide anion, a hexafluorophosphate ion (PF6⁻) or a tetrafluoroborate ion (BF4⁻).

In those cases where the composition incorporates a plasticizer (a liquid component), the proportion of the plasticizer is preferably no more than 50%, and even more preferably no more than 10%, of the weight of the composition.

The transparent electrode substrate 2 includes a conductive layer 3 formed from a conductive material, formed on top of a transparent base material 4 such as a glass plate or a plastic sheet.

The material for the transparent base material 4 preferably displays a high level of light transmittance during actual application, and suitable examples include glass, transparent plastic sheets such as polyethylene terephthalate (PET), polyethylene naphthalate (PEN), polycarbonate (PC) and polyethersulfone (PES), and polished sheets of ceramics such as titanium oxide and alumina.

From the viewpoint of achieving a favorable light transmittance for the transparent electrode substrate 2, the conductive layer 3 is preferably formed from either a single transparent oxide semiconductor such as tin-doped indium oxide (ITO), tin oxide (SnO₂) or fluorine-doped tin oxide (FTO), or a composite of a plurality of such oxides. However, the present invention is not restricted to such configurations, and any material that is appropriate for the targeted use in terms of light transmittance and conductivity can be used. Furthermore, in order to improve the collection efficiency of the oxide semiconductor porous film 5 and the electrolyte layer 7, a metal wiring layer formed from gold, silver, platinum, aluminum, nickel or titanium or the like can also be used, provided the proportion of the surface area covered by the metal wiring layer does not significantly impair the light transmittance of the transparent electrode substrate 2. In those cases where a metal wiring layer is used, the layer is preferably formed with a lattice-type pattern, a striped pattern, or a comb-type pattern or the like, so that as far as possible, light can pass uniformly through the transparent electrode substrate 2.

Formation of the conductive layer 3 can be conducted using a known method that is appropriate for the material used as the conductive layer 3. For example, formation of a conductive layer 3 from an oxide semiconductor such as ITO can be achieved using a thin film formation method such as sputtering, a CVD method or a SPD (spray pyrolysis deposition) method. Taking the light transmittance and conductivity into consideration, the layer is normally formed with a film thickness of 0.05 to 2.0 µm.

The oxide semiconductor porous film 5 is a porous thin film of thickness 0.5 to 50 µm including, as a main component, fine particles of an oxide semiconductor with an average particle size of 1 to 1000 nm, formed from either a single material such as titanium oxide (tiO₂), tin oxide (SnO₂), tungsten oxide (WO₃), zinc oxide (ZnO) or niobium oxide (Nb₂O₅), or a composite material of two or more such oxides.

Formation of the oxide semiconductor porous film 5 can be achieved by first forming either a dispersion prepared by dispersing commercially available fine particles of the oxide semiconductor in a suitable dispersion medium, or a colloid solution prepared using a sol-gel method, adding appropriate additives as desired, and then applying the dispersion or solution using a conventional method such as screen printing, ink-jet printing, roll coating, a doctor blade method, spin coating, or a spray application method. Other methods can also be used, including electrophoretic deposition methods in which the electrode substrate 2 is immersed in the aforementioned colloid solution, and electrophoresis is used to deposit fine particles of the oxide semiconductor onto the electrode substrate 2, methods in which a foaming agent is mixed with the above colloid solution or dispersion, which is then applied and sintered to generate a porous material, and methods in which polymer micro beads are mixed with the above colloid solution or dispersion prior to application, and following application these polymer micro beads are removed by either heat treatment or a chemical treatment, thus forming voids and generating a porous material.

There are no particular restrictions on the sensitizing dye supported on the oxide semiconductor porous film 5, and suitable examples include bipyridine structures, ruthenium complexes or iron complexes with ligands containing a terpyridine structure, metal complexes of porphyrin systems and phthalocyanine systems, and organic dyes such as eocene, rhodamine, merocyanine and coumarin. One or more of these compounds can be appropriately selected in accordance with the target application and the material of the oxide semiconductor porous film being used.

The counter electrode 8 can use an electrode produced by forming a thin film of a conductive oxide semiconductor such as ITO or FTO on a substrate formed from a nonconductive material such as glass, or an electrode in which a conductive material such as gold, platinum or a carbon based material is deposited on the surface of a substrate by either vapor deposition or application or the like. Electrodes in which a layer of platinum or carbon or the like is formed on a thin film of a conductive oxide semiconductor such as ITO or FTO can also be used.

One example of a method for preparing the counter electrode 8 is a method in which a platinum layer is formed by applying chloroplatinic acid and then conducting a heat treatment. Alternatively, methods in which the electrode is formed on the substrate using either vapor deposition or sputtering can also be used.

An example of a method of forming the electrolyte layer 7 on top of the working electrode 6 is a method in which an electrolyte composition solution is first prepared by mixing the aforementioned polymer compound with a suitable organic solvent, adding halogen molecules and additives as necessary, and then stirring the mixture to dissolve all of the components uniformly, and subsequently, an operation in which this prepared electrolyte composition solution is dripped gradually onto the working electrode 6 and subsequently dried is repeated to form the electrolyte layer 7. By using this method, when the electrolyte composition is cast onto the working electrode 6, the electrolyte composition solution can penetrate favorably into, and fill, the voids in the oxide semiconductor porous film 5.

Suitable examples of the above organic solvent used for dissolving the polymer compound include acetonitrile, methoxyacetonitrile, propionitrile, propylene carbonate, diethyl carbonate, methanol, γ-butyrolactone, and N-methylpyrrolidone. The aforementioned polymer compound preferably displays a good level of solubility in at least one of these organic solvents.

Because the electrolyte composition exists in a solid state, volatility and fluidity are poor, meaning when the electrolyte composition is used in a photoelectric conversion element such as a dye-sensitized solar cell, deterioration or loss of the electrolyte through solvent volatilization or the like does not occur, and a high output level and favorable photoelectric conversion characteristics can be achieved. Furthermore, leakage of the electrolyte through gaps in the container, or scattering of the electrolyte caused by damage to the element can also be suppressed, resulting in excellent handling properties.

The definition of a solid state can be easily determined using the following test. First, as shown in FIG. 2A, adhesive tape 13 is stuck to one surface of an approximately 5 cm square glass plate 11, leaving a central section 12 of approximately 20 mm square, and an electrolyte composition solution is then dripped onto the central section 12 enclosed by the adhesive tape 13. After drying, the adhesive tape 13 is peeled off, generating a glass plate 11 with an electrolyte film 14 formed thereon. The film thickness of the electrolyte film 14 is approximately 30 µm. Subsequently, as shown in FIG. 2B, the glass plate 11 is stood up perpendicular to the floor surface 15, and is left to stand at room temperature for 10 hours. After 10 hours, if the electrolyte film 14 has not contacted the floor surface 15, then the fluidity of the electrolyte composition is very low, and the composition is deemed to be a solid. In contrast, if the electrolyte film 14 has contacted the floor surface 15, then the fluidity of the electrolyte composition is high, and the composition is deemed a liquid.

As follows is an even more detailed description of an electrolyte composition and photoelectric conversion element according to the first aspect, based on a series of examples.

### <Polymer Compound Preparation>

A pyridinium based polymer shown below in a formula (1-9) and an imidazolium based polymer shown below in a formula (1-10) were used as polymer compounds containing a quaternary ammonium structure. These polymer compounds were prepared using poly(4-vinylpyridine), poly(N-vinylimidazole) and poly(2-methyl-N-vinylimidazole) as precursors containing a tertiary amine structure, and these precursors were quaternized through the action of an alkyl iodide, and then repeatedly purified to remove any unreacted raw materials and the like, thus forming iodide salts.

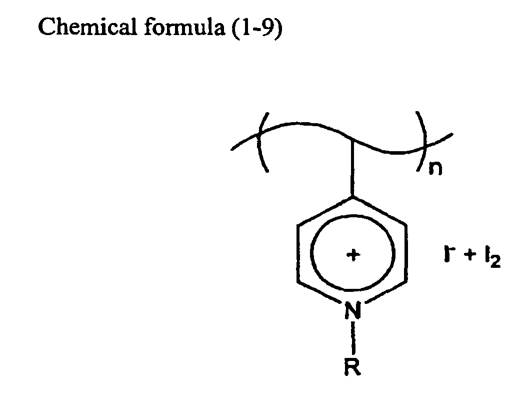

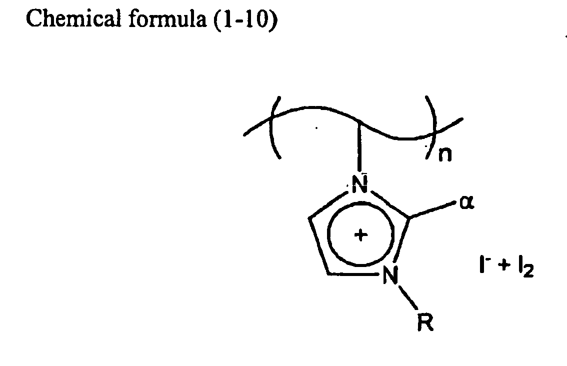

### <Preparation of Electrolyte Composition Solution>

Electrolyte composition solutions were prepared by dissolving each of the above polymer compounds (iodide salts) in a suitable organic solvent, and then adding an iodine solution and stirring until a uniform solution was obtained.

The organic solvent was matched with the solubility of the polymer compound, and the solvent which provided the most favorable solubility was selected from among methanol, acetonitrile and methoxyacetonitrile. The solvent for the iodine solution used the same solvent as that used for dissolving the polymer compound.

### <Preparation of Test Cells according to Examples (1a), (1b) (not according to the invention)>

Using a glass plate with an attached FTO film as the transparent electrode substrate, a slurry-like aqueous dispersion of titanium dioxide with an average particle size of 20 nm was applied to the FTO film (the conductive layer) side of the transparent electrode substrate 2, and following drying, the applied layer was subjected to heat treatment at 450°C for 1 hour, thus forming an oxide semiconductor porous film of thickness 7 µm. The substrate was then immersed overnight in an ethanol solution of a ruthenium bipyridine complex (N3 dye), thus supporting the dye in the porous film and forming the working electrode. Furthermore, an FTO glass electrode substrate with an electrode layer of platinum formed thereon by sputtering was also prepared as the counter electrode.

In order to form the electrolyte layer on the working electrode, an operation was repeated in which the electrolyte composition solution described above was dripped gradually onto the oxide semiconductor porous film surface of the working electrode and subsequently dried. By using this repeating operation, the electrolyte composition was able to penetrate into, and fill, the oxide semiconductor porous film. Following completion of the dripping of the electrolyte composition solution, while the electrolyte was still in a half dried state, the counter electrode described above was superposed above the working electrode and pushed down strongly onto the electrolyte layer, thus bonding the counter electrode and the electrolyte layer. The solvent from the electrolyte composition solution was then removed by thorough drying. The procedure described above was used to prepare dye-sensitized solar cells that functioned as test cells. As shown below in Table 1, these test cells were labeled example (1a)-1 through (1a)-7, and example (1b)-1 through (1b)-7.

### <Preparation of a Test Cell according to Comparative Example 1-1>

The working electrode and the counter electrode used the same electrodes as those prepared for the test cells of the examples (1a) and (1b). An acetonitrile solution containing quaternary imidazolium iodide, lithium iodide, iodine, and 4-tert-butylpyridine was prepared as the electrolyte solution for forming the electrolyte.

The working electrode and the counter electrode were positioned facing one another, and the above electrolyte solution was injected into the space between the electrodes, thus forming the electrolyte layer and completing preparation of the dye-sensitized solar cell that functioned as the test cell for the comparative example 1-1.

### <Preparation of a Test Cell according to Comparative Example 1-2>

With the exception of replacing the titanium oxide slurry used in the procedure described for the examples (1a) and (1b) with a slurry containing titanium oxide nanoparticles and titanium tetraisopropoxide, the working electrode was prepared in the same manner as described in the above examples. The counter electrode used the same platinum coated FTO electrode substrate as that described in the examples (1a) and (1b).

Copper iodide (CuI) was used as the electrolyte for forming the electrolyte layer. Using an acetonitrile saturated solution of CuI as the electrolyte composition solution, an operation was repeated in which the electrolyte composition solution was dripped gradually onto the oxide semiconductor porous film surface of the working electrode and subsequently dried. By using this repeating operation, the CuI was able to penetrate into, and fill, the oxide semiconductor porous film. Following completion of the dripping of the CuI solution, the counter electrode described above was superposed above the working electrode and pushed down strongly onto the electrolyte layer, thus bonding the counter electrode and the electrolyte layer. The solvent from the electrolyte composition solution was then removed by thorough drying. This procedure was used to prepare a dye-sensitized solar cell that functioned as the test cell for the comparative example 1-2.

### <Photoelectric Conversion Characteristics of the Test Cells>

The photoelectric conversion characteristics of each of the prepared test cells were measured. The initial value of the photoelectric conversion efficiency (the initial conversion efficiency) for each test cell is shown in Table 1. Furthermore, the state of the electrolyte layer in each cell, as determined by the above test method illustrated in FIG. 2, is also shown in Table 1.

In Table 1, those rows in which the number begins with (1a) represent examples of dye-sensitized solar cells according to the first aspect, wherein the ammonium structure within the polymer compound is a pyridinium structure as shown in formula (1-9). Furthermore, those rows in which the number begins with (1b) represent examples of dye-sensitized solar cells according to the first aspect, wherein the ammonium structure within the polymer compound is a imidazolium structure as shown in formula (1-10).
(Table 1) (not according to the invention)

| Number | R | α | I⁻/I₂ | State | Initial conversion efficiency (%) |
|---|---|---|---|---|---|
| (1a)-1 | C₂H₅ | - | 10:1 | solid | 4.1 |
| (1a)-2 | n-C₄H₉ | - | 10:1 | solid | 4.4 |
| (1a)-3 | n-C₄H₉ | - | 4:1 | solid | 5.0 |
| (1a)-4 | n-C₄H₉ | - | 2:1 | solid | 4.6 |
| (1a)-5 | n-C₆H₁₃ | - | 10:1 | solid | 4.3 |
| (1a)-6 | n-C₆H₁₃ | - | 4:1 | solid | 4.6 |
| (1a)-7 | C(CH₃)₃ | - | 10:1 | solid | 4.0 |
| (1b)-1 | C₂H₅ | H | 10:1 | solid | 3.0 |
| (1b)-2 | n-C₃H₇ | H | 10:1 | solid | 2.7 |
| (1b)-3 | n-C₃H₇ | H | 4:1 | solid | 3.3 |
| (1b)-4 | n-C₄H₉ | H | 10:1 | solid | 3.1 |
| (1b)-5 | n-C₄H₉ | CH₃ | 10:1 | solid | 2.9 |
| (1b)-6 | n-C₄H₉ | H | 4:1 | solid | 3.6 |
| (1b)-7 | C(CH₃)₃ | H | 10:1 | solid | 3.2 |
| Ref.1-1 | acetonitrile solution | | | liquid | 5.5 |
| Ref. 1-2 | solid CuI | | | solid | 1.4 |

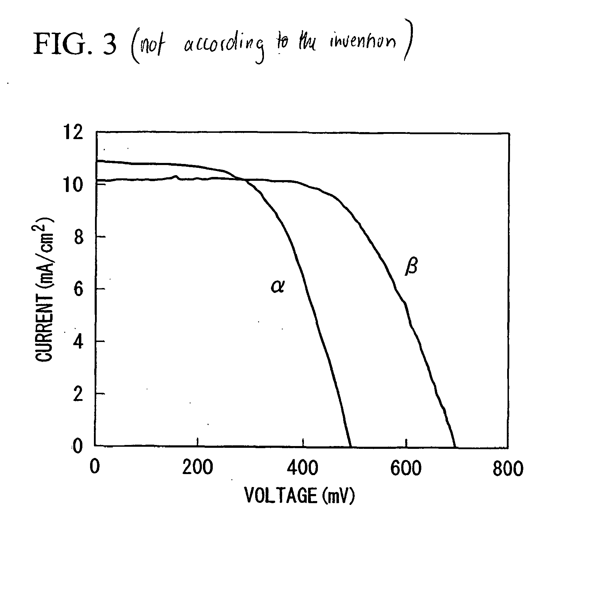

FIG. 3 shows the measurement results for current vs. voltage curves for the test cells of the examples. In FIG. 3, the symbol α represents the measurement results for the test cell according to (1a)-2 in Table 1, and the symbol β represents the measurement results for the test cell according to (1b)-4 in Table 1.

In the test cells from the examples (1a) and (1b), the electrolyte layer had an external appearance similar to a plastic, and tests on the state of the electrolyte confirmed the solid state.

Of the test cells from the examples (1a) and (1b), when the dye-sensitized solar cells of the test cells (1a)-2, (1a)-4 and (1b)-4 were subjected to continued measurement of the photoelectric conversion characteristics, the photoelectric conversion efficiency maintained a level exceeding 90% of the initial value even after 3 hours, and not only was this high level maintained, but problems of electrolyte leakage or solvent volatilization also did not occur.

From these results it was evident that the test cells of the examples (1a) and (1b) displayed favorable photoelectric conversion characteristics, and were also able to withstand continuous usage over extended periods.

In the case of the test cell of the comparative example 1-1, the solvent of the electrolyte gradually volatilized from the point where measurement of the photoelectric conversion characteristics was commenced, and by the time 3 hours had passed, the photoelectric conversion efficiency had fallen to less than 10% of the initial value, and the cell had essentially ceased to operate as a photoelectric conversion element.

In the case of the test cell of the comparative example 1-2, there were no problems of electrolyte leakage or solvent volatilization, but the photoelectric conversion efficiency was a low 1.4% from the start of measurements. Furthermore, after 3 hours the photoelectric conversion efficiency was approximately 70% (approximately 1.0%) of the initial value. In other words, compared with the test cells of the examples (1a) and (1b), the photoelectric conversion characteristics were markedly inferior.

### <Preparation of a Test Cell according to Example (1c) (not according to the invention)>

With the exception of sealing the outside of the two electrolyte substrates with a molten polyolefin based resin after the counter electrode had been bonded to the electrolyte layer and the solvent from the electrolyte composition solution had been removed by thorough drying, a dye-sensitized solar cell was prepared using the same procedure as that described for the test cells of the above examples (1a) and (1b). This cell was labeled as example (1c).

### <Preparation of a Test Cell according to Comparative Example 1-3>

The working electrode and the counter electrode used the same electrodes as those prepared for the test cells of the examples (1a) and (1b). Furthermore, the same acetonitrile solution as that described for the test cell of the comparative example 1-1 was used as the electrolyte solution.

The working electrode and the counter electrode were positioned facing one another with a thermoplastic polyolefin based resin sheet of thickness 50 µm disposed therebetween, and by subsequently heating and melting the resin sheet, the working electrode and the counter electrode were secured together with a gap maintained therebetween. A small aperture was opened in a portion of the counter electrode to function as an injection port for the electrolyte, and the aforementioned electrolyte solution was injected in through this port to form the electrolyte layer. The injection port was then sealed with a combination of an epoxy based sealing resin and a polyolefin based resin, thus completing preparation of a dye-sensitized solar cell. This was used as the test cell for the comparative example 1-3.

### <Durability Testing of Test Cells>

One test cell from the example (1c) and one test cell of the comparative example 1-3 were placed in a thermostatic chamber at a temperature of 80°C and left for a period of 7 days. The test cells were then removed from the thermostatic chamber, and when the external appearance of each cell was inspected visually, the test cell of the comparative example 1-3 showed a deterioration in the sealing provided by the polyolefm, and a portion of the electrolyte solution had volatilized, resulting in the generation of both large and small gas bubbles. As a result, the cell essentially ceased to operate as a photoelectric conversion element.

The test cell of the example (1c) showed no obvious variations in external appearance such as gas bubble formation within the electrolyte layer.

### <Destructive Testing of Test Cells>

One test cell from the example (1c) and one test cell of the comparative example 1-3 were broken with a hammer from the glass substrate side of the cell, and when the cell was then held with the broken section facing downward, the electrolyte leaked from the test cell in the case of the comparative example 1-3. In contrast, in the test cell according to the example (1c), because the electrolyte layer was solid, no electrolyte leakage occurred.

### <Preparation of Test Cells according to Examples (1d) (not according to the invention)>

With the exception of using one of the compounds of the formulas (1-11) through (1-20) shown below as the polymer compound, an electrolyte composition solution was prepared and this electrolyte composition solution was then used to prepare a dye-sensitized solar cell to act as a test cell, in the same manner as in the examples (1a) and (1b).

The photoelectric conversion characteristics of each of the prepared test cells were measured, and the initial value of the photoelectric conversion efficiency (the initial conversion efficiency) for each test cell is shown in Table 2. Furthermore, the state of the electrolyte layer in each cell, as determined by the above test method illustrated in FIG. 2, is also shown in Table 2.

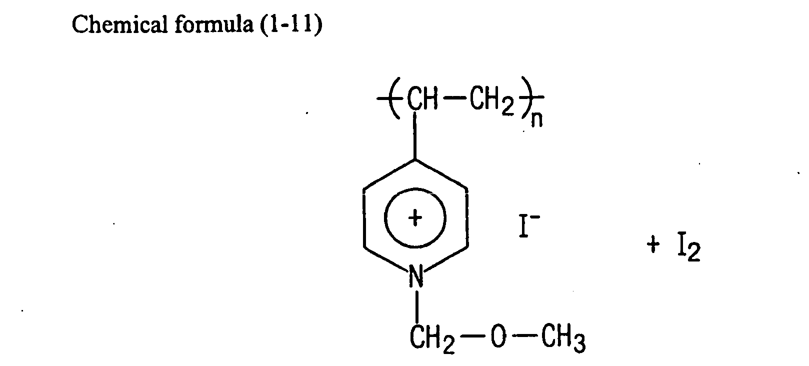

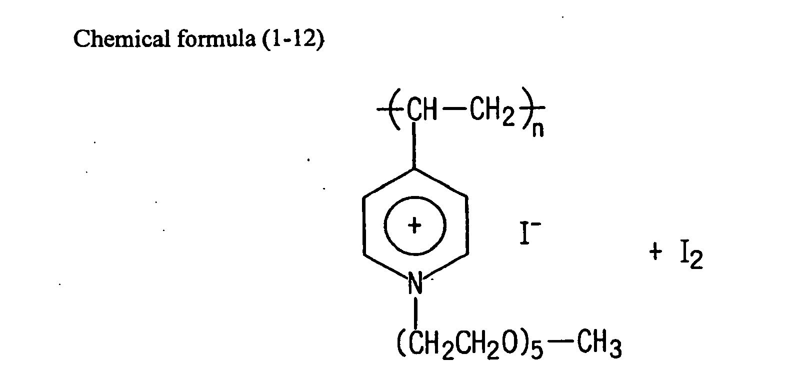

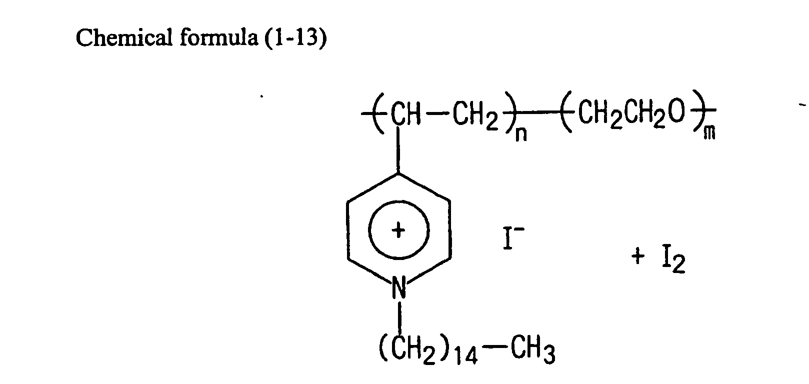

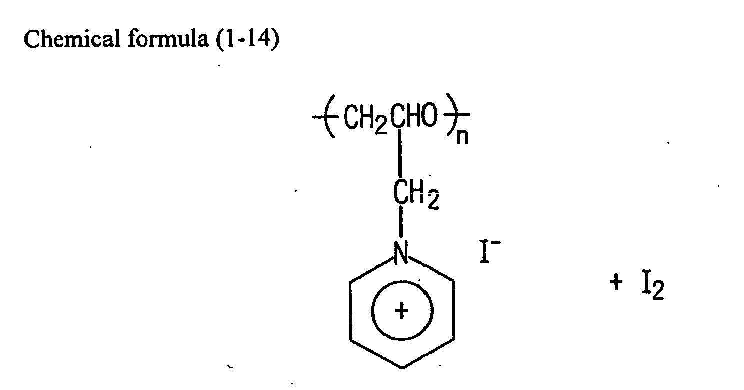

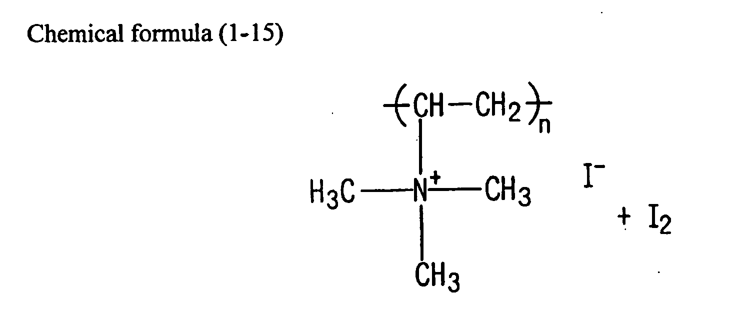

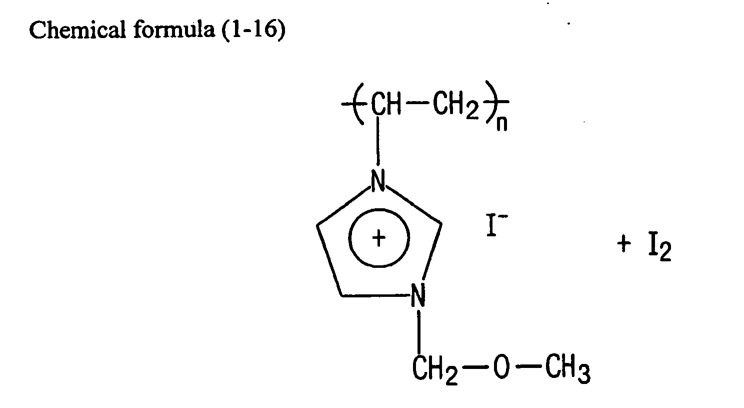

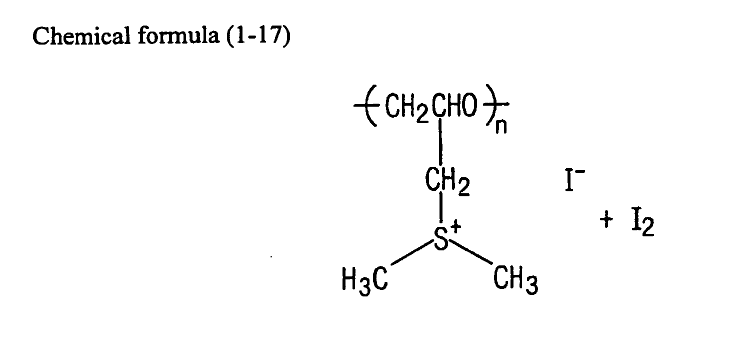

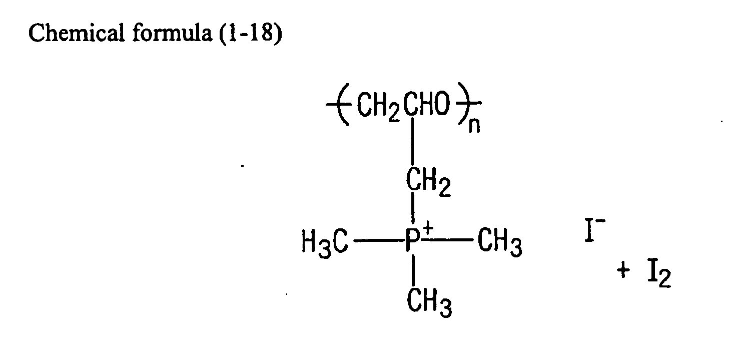

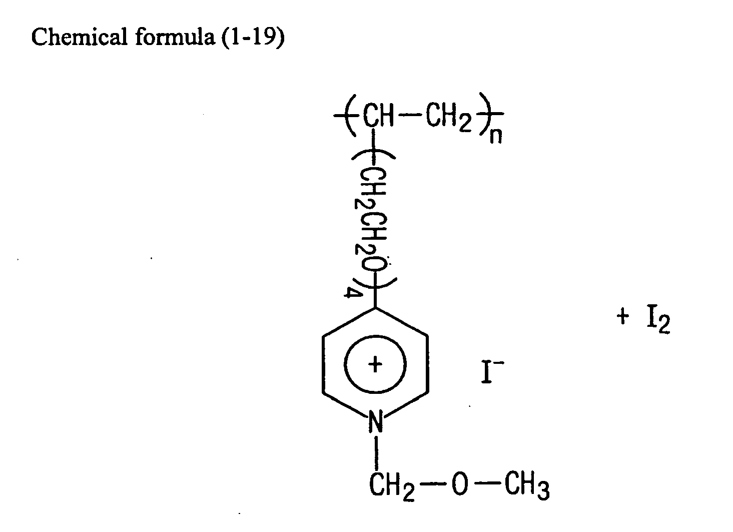

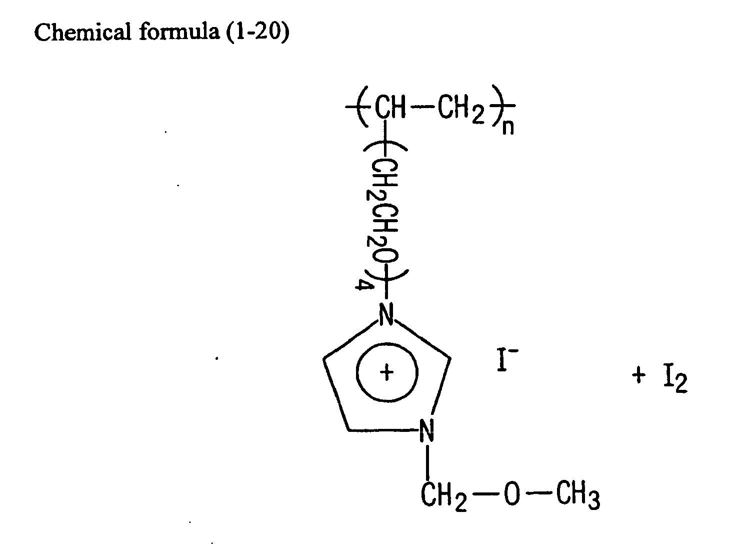

**(Table 2) (not according to the invention)**

| Number | Polymer compound | I⁻/I₂ | State | Initial conversion efficiency (%) |
|---|---|---|---|---|
| (1d)-1 | formula (1-11) | 10:1 | solid | 4.1 |
| (1d)-2 | formula (1-11) | 4:1 | solid | 4.2 |
| (1d)-3 | formula (1-11) | 2:1 | solid. | 3.2 |
| (1d)-4 | formula (1-12) | 10:1 | solid | 4.4 |
| (1d)-5 | formula (1-13) | 10:1 | solid | 4.1 |
| (1d)-6 | formula (1-14) | 10:1 | solid | 3.9 |
| (1d)-7 | formula (1-15) | 10:1 | solid | 3.1 |
| (1d)-8 | formula (1-16) | 10:1 | solid | 3.5 |
| (1d)-9 | formula (1-16) | 4:1 | solid | 2.8 |
| (1d)-10 | formula (1-17) | 10:1 | solid | 3.2 |
| (1d)-11 | formula (1-17) | 4:1 | solid | 2.8 |
| (1d)-12 | formula (1-18) | 10:1 | solid | 3.6 |
| (1d)-13 | formula (1-19) | 10:1 | solid | 4.2 |
| (1d)-14 | formula (1-20) | 10:1 | solid | 3.8 |

When the measurements of the photoelectric conversion characteristics of the dye-sensitized solar cells from each of the examples (1d) were continued, even after 3 hours, the type of marked fall in photoelectric conversion efficiency observed in the comparative example 1-1 was not seen, and the cells continued to operate well. Furthermore, problems of electrolyte leakage or solvent volatilization also did not occur.

From these results it was evident that the test cells of the example (1d) displayed favorable photoelectric conversion characteristics, did not suffer from volatilization in the manner of a conventional volatile electrolyte solution (comparative example 1-1), and were able to be used for extended periods.

Furthermore, the test cells (1d)-1, (1d)-4 and (1d)-5 from the example (1d), together with the test cells (1a)-1 and (1b)-1 from the examples (1a) and (1b), and the test cells of the comparative examples 1-1 and 1-2 were prepared and then left to stand in an unsealed state for 14 days, and after the 14 days had elapsed the cells were tested for short circuit current. In the test cells from the comparative examples 1-1 and 1-2, almost no power generation was recorded.

In contrast, in the test cells (1a)-1 and (lb)-1, power generation was possible, and the short circuit current value after 14 days was up to 80% of the initial value. Furthermore, with the test cells (1d)-1, (1d)-4 and (1d)-5, the short circuit current value after 14 days was at least 85% of the initial value.

Normally, during operation (power generation) of a dye-sensitized solar cell, the electrolyte layer expands and contracts as a result of heat variation. Consequently, when a dye-sensitized solar cell is used continuously, it is thought that this expansion and contraction of the electrolyte layer can cause separation between the electrolyte layer and the working electrode, and between the electrolyte layer and the counter electrode, thus lowering the short circuit current value.

The polymer compounds represented by the formulas (1-11) through (1-14), and (1-16) through (1-20) contain a polyethylene oxide structure (including CH₃-O-CH₂-groups) within either the principal chain or a side chain, and consequently display excellent flexibility when compared with the polymer compounds used in the examples (1a) and (1b). If a polymer compound that contains this type of cation structure and counter anion, and also displays excellent flexibility, is used as the essential component of the electrolyte composition, then the adhesion between the electrolyte layer and the working electrode, and between the electrolyte layer and the counter electrode can be maintained with good stability. As a result, separation between the electrolyte layer and the working electrode, and between the electrolyte layer and the counter electrode, caused by expansion and contraction of the electrolyte layer during continuous operation of the dye-sensitized solar cell, can be suppressed, enabling better suppression of any deterioration in the cell characteristics.

From the above it is evident that in an electrolyte composition according to the first aspect of the present invention, a high level of flexibility is preferred. When this type of flexible electrolyte composition is used for the electrolyte layer of a dye-sensitized solar cell, in which the electrolyte layer is provided between the working electrode and the counter electrode, the adhesion at the interfaces between the electrolyte composition and the working electrode, and between the electrolyte composition and the counter electrode can be maintained with good stability. This enables the production of a dye-sensitized solar cell that displays even better durability, and displays excellent cell characteristics even after extended usage.

### <Preparation of a Test Cell according to Example (1e) (not according to the invention)>

With the exception of sealing the outside of the two electrolyte substrates with a molten polyolefin based resin after the counter electrode had been bonded to the electrolyte layer and the solvent from the electrolyte composition solution had been removed by thorough drying, a dye-sensitized solar cell was prepared using the same procedure as that described for the test cells of the above examples (1d). This test cell was labeled as example (1e).

### <Durability Testing of Test Cells>

A test cell from the example (1e) was placed in a thermostatic chamber at a temperature of 80°C and left for a period of 7 days. The test cell was then removed from the thermostatic chamber, and the external appearance was examined visually.

The test cell of the example (1e) showed no obvious variations in external appearance such as gas bubble formation within the electrolyte layer.

### <Destructive Testing of Test Cells>

A test cell from the example (1e) was broken with a hammer from the glass substrate side of the cell, and the cell was then held with the broken section facing downward. In this test cell according to the example (1e), because the electrolyte layer was solid, no electrolyte leakage occurred.

Next, an electrolyte composition and a photoelectric conversion element according to the second aspect of which is according to the present invention are described with reference to the dye-sensitized solar cell of the embodiment shown in FIG. 1. The area in which the photoelectric conversion element according to the second aspect of the present invention differs from the first aspect is in the nature of the electrolyte composition.

The dye-sensitized solar cell 1 shown in FIG. 1 includes a working electrode 6, including an oxide semiconductor porous film 5, formed from fine particles of an oxide semiconductor such as titanium oxide with a photosensitizing dye supported thereon, provided on top of a transparent electrode substrate 2, and a counter electrode 8 provided opposing this working electrode 6. An electrolyte layer 7 is formed between the working electrode 6 and the counter electrode 8.

The electrolyte composition that forms the electrolyte layer 7 includes, as an essential component, a polymer compound containing a cation structure formed by partial oxidation of a π-conjugated polymer as the principal chain of the polymer, and a halide ion and/or a polyhalide as the counter anion.

The polymer compound may be either a single polymer compound, or a mixture of a plurality of different polymer compounds. The molecular weight for the polymer compound is within a range from several hundred to several million, and preferably from several thousand to several hundred thousand, and even more preferably in the order of several tens of thousands.

Suitable examples of the polymer compound include materials produced by taking an undoped polymer with a principal chain such as a polythiophene based polymer shown below in the formula (2-1), a polyfuran based polymer shown below in the formula (2-2), a polypyrrole based polymer shown below in the formula (2-3), a polyaniline or a derivative thereof, or a polyphenylenevinylene shown below in the formula (2-4) or a derivative thereof, and then doping this polymer with a halogen such as iodine or another oxidizing agent, thus partially oxidizing the polymer and forming a cation structure.

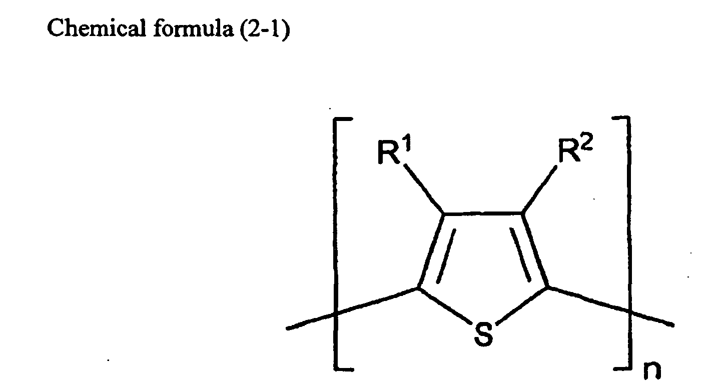

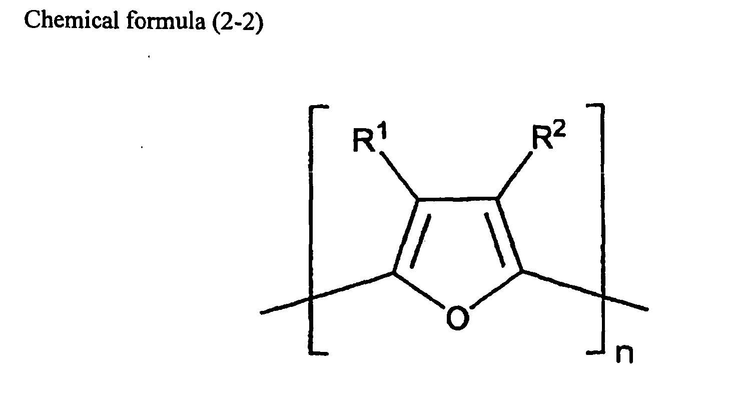

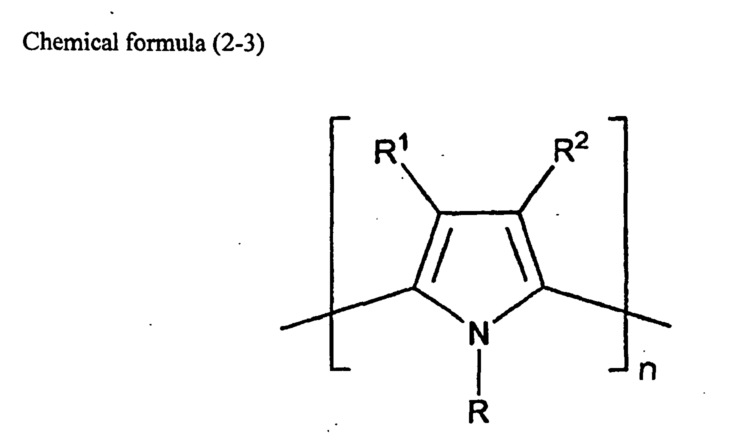

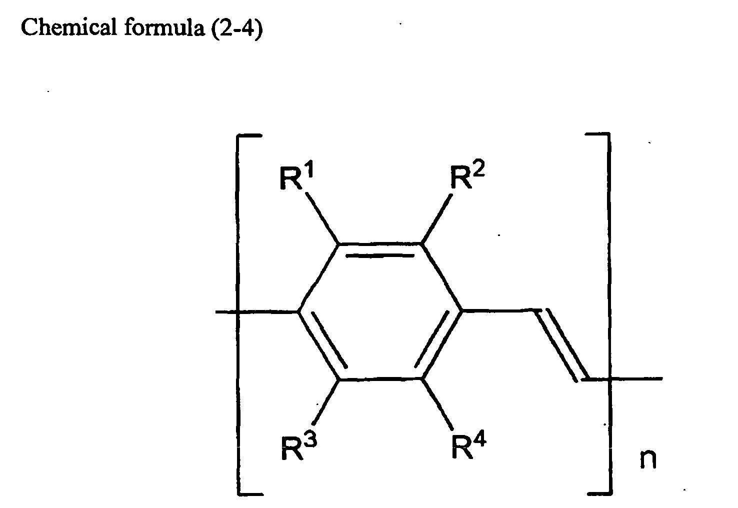

In the formulas (2-1), (2-2), (2-3) and (2-4), the groups R¹, R², R³ and R⁴ can be selected independently, with each group representing a hydrogen atom; a halogen atom such as fluorine, chlorine, bromine or iodine; a cyano group; a straight chain alkyl group such as a methyl, ethyl, propyl, butyl (n-butyl), pentyl (n-pentyl), hexyl, octyl, dodecyl, hexadecyl or octadecyl group; a branched alkyl group such as an isopropyl, isobutyl, sec-butyl, tert-butyl, isopentyl or neopentyl group; a straight chain or branched alkoxy group such as a methoxy, ethoxy, propoxy, isopropoxy, butoxy, isobutoxy, sec-butoxy or tert-butoxy group; an alkenyl group such as a vinyl, propenyl, allyl, butenyl or oleyl group; an alkynyl group such as an ethynyl, propynyl or butynyl group; an alkoxyalkyl group such as a methoxymethyl, 2-methoxyethyl, 2-ethoxyethyl or 3-ethoxypropyl group; a polyether group such as a C₂H₅O(CH₂CH₂O)ₘCH₂CH₂ group (wherein m is an integer of at least 1) or a CH₃O(CH₂CH₂O)OCH₂CH₂ group (wherein m is an integer of at least 1); or a derivative of one of these groups substituted with a halogen such as fluorine, such as a fluoromethyl group.

Furthermore, the substituents R¹ and R² may also form a cyclic structure within the molecule, so that the substituents R¹ and R² contain bivalent chains which, together with additional carbon atoms, form at least one 3 to 7-membered ring (namely, a 3-membered ring, 4-membered ring, 5-membered ring, 6-membered ring or 7-membered ring), thus forming a saturated or unsaturated hydrocarbon cyclic structure. The cyclic linkage chain may also include other linkages such as carbonyl, ether, ester, amide, sulfide, sulfinyl, sulfonyl or imino linkages. Examples of this type of cyclic linkage chain (R¹, R²) include straight chain or branched alkylene groups such as methylene, ethylene, propylene, trimethylene or tetramethylene groups; alkenylene groups such as a vinylene, methylvinylene or propenylene groups; alkynylene groups such as ethynylene groups; alkylenedioxy groups such as ethylenedioxy or propylenedioxy groups; bivalent groups with an ether linkage such as alkyleneoxyalkylene groups; or polyether groups.

In the formula (2-3), the substituent R represents a straight chain alkyl group such as a methyl, ethyl, propyl, n-butyl, n-pentyl, n-hexyl or n-octyl group; a branched alkyl group such as an isopropyl, isobutyl, sec-butyl, tert-butyl, isopentyl or neopentyl group; a straight chain or branched alkoxy group such as a methoxy, ethoxy, propoxy, isopropoxy, butoxy, isobutoxy, sec-butoxy or tert-butoxygroup; an alkynyl group such as a vinyl, propenyl, allyl, butenyl or oleyl group; an alkynyl group such as an ethynyl, propynyl or butynyl group; an alkoxyalkyl group such as a methoxymethyl, 2-methoxyethyl, 2-ethoxyethyl or 3-ethoxypropyl group; a polyether group such as a C₂H₅O(CH₂CH₂O)ₘCH₂CH₂ group (wherein m is an integer of at least 1) or a CH₃O(CH₂CH₂O)ₘCH₂CH₂ group (wherein m is an integer of at least 1); or a derivative of one of these groups substituted with a halogen such as fluorine, such as a fluoromethyl group.

The aforementioned undoped polymer can be produced by conventional polymerization methods, using thiophene, furan, pyrrole, aniline, or derivatives of these compounds as the raw material. Furthermore, commercially available polymers can also be used, although of course the present invention is not restricted to such cases.

Examples of suitable thiophene derivatives include 3-methylthiophene, 3-ethylthiophene, 3-propylthiophene, 3-butylthiophene, 3-pentylthiophene, 3-hexylthiophene, 3-heptylthiophene, 3-octylthiophene, 3-nonylthiophene, 3-decylthiophene, 3-dodecylthiophene, 3-hexadecylthiophene, 3-octadecylthiophene, 3-fluorothiophene, 3-chlorothiophene, 3-bromothiophene, 3-cyanothiophene, 3,4-dimethylthiophene, 3,4-diethylthiophene, 3,4-butylenethiophene, 3,4-methylenedioxythiophene, and 3,4-ethylenedioxythiophene. A polythiophene based polymer produced by polymerizing thiophene or one of the above thiophene derivatives can be favorably used as the electrolyte composition of the present invention.

Specific examples of polythiophene based polymers include polythiophene, which is represented by the formula (2-1) when R¹ and R² are both hydrogen atoms, polyhexylthiophene, wherein R¹ is a hexyl group and R² is a hydrogen atom, and polyethylenedioxythiophene (PEDOT), wherein R¹ and R² are linked in a cyclic structure, and the combination of R¹ and R² forms an ethylenedioxy group.

Polymers in which at least one of R¹ and R² has a structure with a comparatively long chain are preferred. Such polymers display a higher level of solubility in the organic solvent, making the operation of forming the electrolyte layer on the electrode substrate using the procedure described below far simpler.

Examples of pyrrole derivatives include 3-methylpyrrole, 3-ethylpyrrole, 3-propylpyrrole, 3-butylpyrrole, 3-pentylpyrrole, 3-hexylpyrrole, 3-heptylpyrrole, 3-octylpyrrole, 3-nonylpyrrole, 3-decylpyrrole, 3-dodecylpyrrole, 3-hexadecylpyrrole, 3-octadecylpyrrole, 3-fluoropyrrole, 3-chloropyrrole, 3-bromopyrrole, 3-cyanopyrrole, 3,4-dimethylpyrrole, 3,4-diethylpyrrole, 3,4-butylenepyrrole, 3,4-methylenedioxypyrrole, and 3,4-ethylenedioxypyrrole. A polypyrrole based polymer produced by polymerizing pyrrole or one of the above pyrrole derivatives can be favorably used as the electrolyte composition of the invention.

Examples of furan derivatives include 3-methylfuran, 3-ethylfuran, 3-propylfuran, 3-butylfuran, 3-pentylfuran, 3-hexylfuran, 3-heptylfuran, 3-octylfuran, 3-nonylfuran, 3-decylfuran, 3-dodecylfuran, 3-hexadecylfuran, 3-octadecylfuran, 3-fluorofuran, 3-chlorofuran, 3-bromofuran, 3-cyanofuran, 3,4-dimethylfuran, 3,4-diethylfuran, 3,4-butylenefuran, 3,4-methylenedioxyfuran, and 3,4-ethylenedioxyfuran. A polyfuran based polymer produced by polymerizing furan or one of the above furan derivatives can be favorably used as the electrolyte composition of the present invention.

Examples of aniline derivatives include N-alkylanilines, 1-aminopyrene, o-phenylenediamine, and arylamines. A polyaniline based polymer produced by polymerizing aniline or one of the above aniline derivatives can be favorably used as the electrolyte composition of the present invention.

Polyphenylenevinylene or derivatives thereof can be synthesized via a precursor polymer by conventional methods that use heat treatment or the like.

This type of undoped polymer is partially oxidized by the addition of a dopant such as a halogen, thus forming a polymer compound with the type of cation structure shown in formulas (2-5) to (2-7) (namely, a cationic polymer). Formula (2-5) represents a cationic polymer produced by the partial oxidation of the polythiophene based polymer shown in formula (2-1). Formula (2-6) represents a cationic polymer produced by the partial oxidation of the polypyrrole based polymer shown in formula (2-2). Formula (2-7) represents a cationic polymer produced by the partial oxidation of the polyfuran based polymer shown in formula (2-3). Furthermore, in the formulas (2-5) to (2-7), δ⁺ represents the positive charge retained by the cationic polymer.

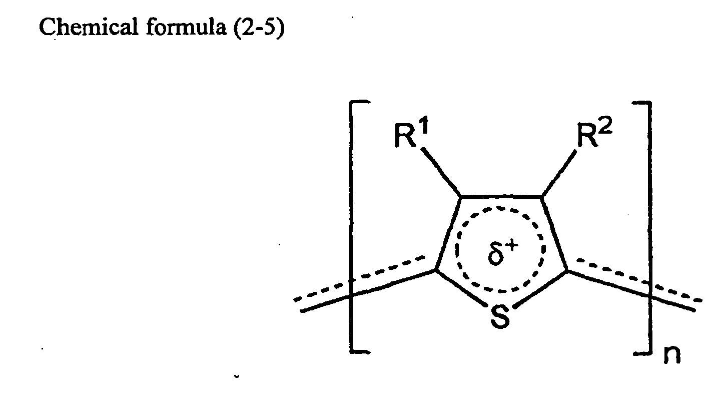

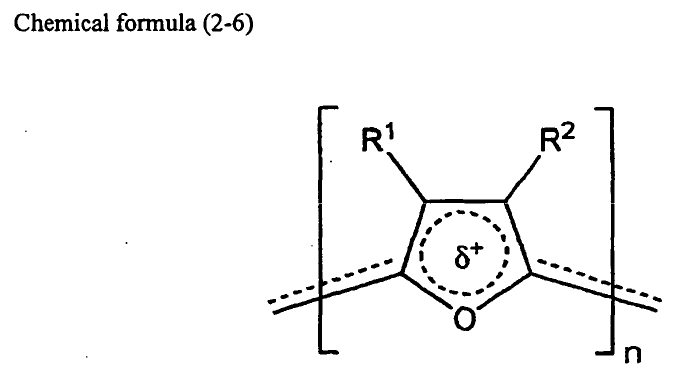

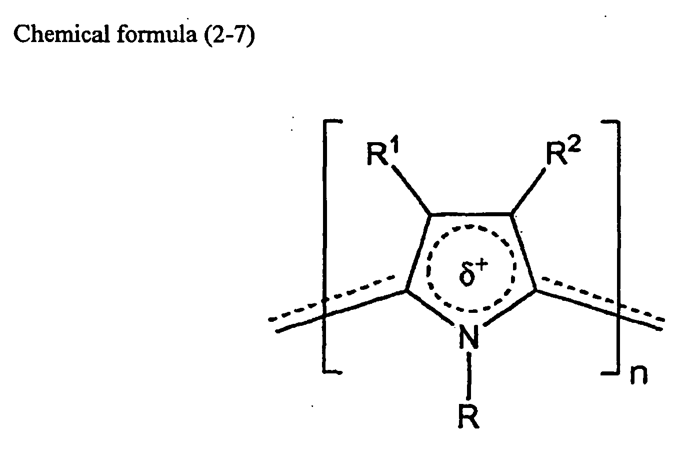

Examples of possible counter anions for the above cationic polymers include halide ions such as iodide ions, bromide ions and chloride ions; and polyhalide ions such as Br₃⁻, I₃⁻, I₅⁻, I₇⁻, Cl₂I⁻, ClI₂⁻, Br₂I⁻ and BrI₂⁻.

In those cases where halide ions are used as the counter anions for the cationic polymer, a halide salt such as lithium iodide, sodium iodide, potassium iodide, lithium bromide, sodium bromide or potassium bromide may be added to the electrolyte composition. Suitable examples of the counter cations for these halide salts include alkali metal ions such as lithium.

Polyhalide ions are anions including a plurality of halogen atoms, and can be obtained by reacting a halide ion such as Cl⁻, Br or I⁻ with a halogen molecule. This halogen molecule can use either simple halogen molecules such as Cl₂, Br₂ and I₂, and/or interhalogen compounds such as ClI, BrI and BrCl.

Although addition of halogen molecules is not essential, such halogen molecule addition is preferred. In those cases where halogen molecules are added to form polyhalide ions, the halide ion and the polyhalide ion form a redox pair, enabling an improvement in the photoelectric conversion characteristics. There are no particular restrictions on the ratio of the halogen molecules to the halide ions, and molar ratios from 0% to 100% are preferred.

In conventional gel-like electrolyte compositions where a liquid electrolyte is gelled and solidified, the polymer performs the role of the curing agent for curing the liquid electrolyte.

In contrast, in an electrolyte composition of the present invention, the polymer compound described above displays conductivity itself, performs an important role in charge transfer in an electrolyte composition containing a redox pair, and is a solid.

A variety of additives such as ionic liquids; organic nitrogen compounds such as 4-tert-butylpyridine, 2-vinylpyridine and N-vinyl-2-pyrrolidone; and other additives such as lithium salts, sodium salts, magnesium salts, iodide salts, thiocyanates and water can be added to the electrolyte composition of the present invention if required, provided such addition does not impair the properties and characteristics of the electrolyte composition. Examples of the aforementioned ionic liquids include salts that are liquid at room temperature, and include a cation such as a quaternary imidazolium, quaternary pyridinium or quaternary ammonium ion, and an anion such as an iodide ion, a bis-trifluoromethylsulfonylimide anion, a hexafluorophosphate ion (PF₆⁻) or a tetrafluoroborate ion (BF₄⁻).

In those cases where the composition incorporates a plasticizer (a liquid component), the proportion of the plasticizer is preferably no more than 50%, and even more preferably no more than 10%, of the weight of the electrolyte composition.

The transparent electrode substrate 2 includes a conductive layer 3 formed from a conductive material, formed on top of a transparent base material 4 such as a glass plate or a plastic sheet.

The material for the transparent base material 4 preferably displays a high level of light transmittance during actual application, and suitable examples include glass, transparent plastic sheets such as polyethylene terephthalate (PET), polyethylene naphthalate (PEN), polycarbonate (PC) and polyethersulfone (PES), and polished sheets of ceramics such as titanium oxide and alumina.

From the viewpoint of achieving a favorable light transmittance for the transparent electrode substrate 2, the conductive layer 3 is preferably formed from either a single transparent oxide semiconductor such as tin-doped indium oxide (ITO), tin oxide (SnO₂) or fluorine-doped tin oxide (FTO), or a composite of a plurality of such oxides. However, the present invention is not restricted to such configurations, and any material that is appropriate for the targeted use in terms of light transmittance and conductivity can be used. Furthermore, in order to improve the collection efficiency of the oxide semiconductor porous film 5 and the electrolyte layer 7, a metal wiring layer formed from gold, silver, platinum, aluminum, nickel or titanium or the like can also be used, provided the proportion of the surface area covered by the metal wiring layer does not significantly impair the light transmittance of the transparent electrode substrate 2. In those cases where a metal wiring layer is used, the layer is preferably formed with a lattice-type pattern, a striped pattern, or a comb-type pattern or the like, so that as far as possible, light can pass uniformly through the transparent electrode substrate 2.

Formation of the conductive layer 3 can be conducted using a known method that is appropriate for the material used as the conductive layer 3. For example, formation of a conductive layer 3 from an oxide semiconductor such as ITO can be achieved using a thin film formation method such as sputtering, a CVD method or a SPD (spray pyrolysis deposition) method. Taking the light transmittance and conductivity into consideration, the layer is normally formed with a film thickness of 0.05 to 2.0 µm.

The oxide semiconductor porous film 5 is a porous thin film of thickness 0.5 to 50 µm including, as a main component, fine particles of an oxide semiconductor with an average particle size of 1 to 1000 nm, formed from either a single material such as titanium oxide (TiO₂), tin oxide (SnO₂), tungsten oxide (WO₃), zinc oxide (ZnO) or niobium oxide (Nb₂O₅), or a composite material of two or more such oxides.

Formation of the oxide semiconductor porous film 5 can be achieved by first forming either a dispersion prepared by dispersing commercially available fine particles of the oxide semiconductor in a suitable dispersion medium, or a colloid solution prepared using a sol-gel method, adding appropriate additives as desired, and then applying the dispersion or solution using a conventional method such as screen printing, ink-jet printing, roll coating, a doctor blade method, spin coating, or a spray application method. Other methods can also be used, including electrophoretic deposition methods in which the electrode substrate 2 is immersed in the aforementioned colloid solution, and electrophoresis is used to deposit fine particles of the oxide semiconductor onto the electrode substrate 2, methods in which a foaming agent is mixed with the above colloid solution or dispersion, which is then applied and sintered to generate a porous material, and methods in which polymer micro beads are mixed with the above colloid solution or dispersion prior to application, and following application these polymer micro beads are removed by either heat treatment or a chemical treatment, thus forming voids and generating a porous material.

There are no particular restrictions on the sensitizing dye supported on the oxide semiconductor porous film 5, and suitable examples include bipyridine structures, ruthenium complexes or iron complexes with ligands containing a terpyridine structure, metal complexes of porphyrin systems and phthalocyanine systems, and organic dyes such as eocene, rhodamine, merocyanine and coumarin. One or more of these compounds can be appropriately selected in accordance with the target application and the material of the oxide semiconductor porous film being used.

The counter electrode 8 can use an electrode produced by forming a thin film of a conductive oxide semiconductor such as ITO or FTO on a substrate formed from a nonconductive material such as glass, or an electrode in which a conductive material such as gold, platinum or a carbon based material is deposited on the surface of a substrate by either vapor deposition or application or the like. Electrodes in which a layer of platinum or carbon or the like is formed on a thin film of a conductive oxide semiconductor such as ITO or FTO can also be used.

One example of a method for preparing the counter electrode 8 is a method in which a platinum layer is formed by applying chloroplatinic acid and then conducting a heat treatment. Alternatively, methods in which the electrode is formed on the substrate using either vapor deposition or sputtering can also be used.

An example of a method of forming the electrolyte layer 7 on top of the working electrode 6 is a method in which an electrolyte composition solution is first prepared by mixing the aforementioned polymer compound with a suitable organic solvent, adding halogen molecules and additives as necessary, and then stirring the mixture to dissolve all of the components uniformly, and subsequently, an operation in which this prepared electrolyte composition solution is dripped gradually onto the working electrode 6 and subsequently dried is repeated to form the electrolyte layer 7. By using this method, when the electrolyte composition is cast onto the working electrode 6, the electrolyte composition solution can penetrate favorably into, and fill, the voids in the oxide semiconductor porous film 5.

Suitable examples of the above organic solvent used for dissolving the polymer compound include tetrahydrofuran, methyl ethyl ketone, dimethylformamide, acetonitrile, methoxyacetonitrile, propionitrile, propylene carbonate, diethyl carbonate, methanol, γ-butyrolactone, and N-methylpyrrolidone. The aforementioned polymer compound preferably displays a good level of solubility in at least one of these organic solvents.

Alternatively, the electrolyte layer can also be formed using a method in which the monomer for generating the above polymer compound is first used to fill the semiconductor porous electrode in advance, and the monomer is then polymerized using a chemical and/or electrochemical technique.

Because the electrolyte composition of the present invention exists in a solid state, volatility and fluidity are poor, meaning when the electrolyte composition is used in a photoelectric conversion element such as a dye-sensitized solar cell, deterioration or loss of the electrolyte through solvent volatilization or the like does not occur, the output level and the photoelectric conversion characteristics are excellent, and the cell is able to function stably over extended periods. Furthermore, leakage of the electrolyte through gaps in the container, or scattering of the electrolyte caused by damage to the element can also be suppressed, resulting in excellent handling properties.

The definition of a solid state in the present invention can be easily determined using the following test. First, as shown in FIG. 2A, adhesive tape 13 is stuck to one surface of an approximately 5 cm square glass plate 11, leaving a central section 12 of approximately 20 mm square, and an electrolyte composition solution is then dripped onto the central section 12 enclosed by the adhesive tape 13. After drying, the adhesive tape 13 is peeled off, generating a glass plate 11 with an electrolyte film 14 formed thereon. The film thickness of the electrolyte film 14 is approximately 30 µm. Subsequently, as shown in FIG. 2B, the glass plate 11 is stood up perpendicular to the floor surface 15, and is left to stand at room temperature for 10 hours. After 10 hours, if the electrolyte film 14 has not contacted the floor surface 15, then the fluidity of the electrolyte composition is very low, and the composition is deemed to be a solid. In contrast, if the electrolyte film 14 has contacted the floor surface 15, then the fluidity of the electrolyte composition is high, and the composition is deemed a liquid.

As follows is an even more detailed description of an electrolyte composition and photoelectric conversion element according to the second aspect of the present invention, based on a series of examples.

### <Preparation of Test Cells according to Example (2a)>

Using a glass plate with an attached FTO film as the transparent electrode substrate, a slurry-like aqueous dispersion of titanium dioxide with an average particle size of 20 nm was applied to the FTO film (the conductive layer) side of the transparent electrode substrate 2, and following drying, the applied layer was subjected to heat treatment at 450°C for 1 hour, thus forming an oxide semiconductor porous film of thickness 7 µm. The substrate was then immersed overnight in an ethanol solution of a ruthenium bipyridine complex (N3 dye), thus supporting the dye in the porous film and forming the working electrode. Furthermore, an FTO glass electrode substrate with an electrode layer of platinum formed thereon by sputtering was also prepared as the counter electrode.

Subsequently, an electrolyte layer was formed on the working electrode using the method described below.

First, a soluble polythiophene was synthesized using a known chemical oxidation polymerization method. This soluble polythiophene was then dissolved in tetrahydrofuran to form an electrolyte precursor solution.

An operation was then repeated in which this electrolyte precursor solution was dripped gradually onto the oxide semiconductor porous film surface of the working electrode and subsequently dried. By using this repeating operation, a polythiophene film was formed on the oxide semiconductor porous film. This polythiophene film was then immersed in a propylene carbonate solution containing LiI and I₂, and oxidized using an electrochemical method. This caused the doping of the polythiophene film with a redox pair of iodide ion and polyiodide, thus completing formation of the electrolyte layer.

While this electrolyte layer was still in a half dried state, the counter electrode described above was superposed above the working electrode and pushed down strongly onto the electrolyte layer, thus bonding the counter electrode and the electrolyte layer. The solvent from the electrolyte composition solution was then removed by thorough drying. The procedure described above was used to prepare dye-sensitized solar cells that functioned as test cells. As shown below in Table 3, these test cells were labeled example (2a)-1 through (2a)-3.

### <Preparation of a Test Cell according to Example (2b)>

The example (2b) differs from the examples (2a) in that the electrolyte layer is formed from a polypyrrole film. The remaining construction of the test cell is the same as that of the examples (2a), and consequently the description is omitted here. The method of forming the electrolyte layer is described below.

First, a soluble polypyrrole was synthesized using a known chemical oxidation polymerization method. This soluble polypyrrole was then dissolved in N-methyl-2-pyrrolidone to form an electrolyte precursor solution.

An operation was then repeated in which this electrolyte precursor solution was dripped gradually onto the oxide semiconductor porous film surface of the working electrode and subsequently dried. By using this repeating operation, a polypyrrole film was formed on the oxide semiconductor porous film. This polypyrrole film was then immersed in a propylene carbonate solution containing LiI and I₂, and oxidized using an electrochemical method. This caused the doping of the polypyrrole film with a redox pair of iodide ion and polyiodide, thus completing formation of the electrolyte layer.

Then, in a similar manner to the example (2a), the counter electrode was bonded to the electrolyte layer, and the solvent from the electrolyte composition solution was removed by thorough drying, thus completing preparation of a dye-sensitized solar cell that functioned as a test cell. As shown below in Table 3, this test cell was labeled example (2b)-1.

### <Preparation of a Test Cell according to Example (2c)>

The example (2c) differs from the examples (2a) in that the electrolyte layer is formed from a polyaniline film. The remaining construction of the test cell is the same as that of the examples (2a), and consequently the description is omitted here. The method of forming the electrolyte layer is described below.

First, a soluble polyaniline was synthesized using a known chemical oxidation polymerization method. This soluble polyaniline was then dissolved in N-methyl-2-pyrrolidone to form an electrolyte precursor solution:

An operation was then repeated in which this electrolyte precursor solution was dripped gradually onto the oxide semiconductor porous film surface of the working electrode and subsequently dried. By using this repeating operation, a polyaniline film was formed on the oxide semiconductor porous film. This polyaniline film was then immersed in a propylene carbonate solution containing LiI and I₂, and oxidized using an electrochemical method. This caused the doping of the polyaniline film with a redox pair of iodide ion and polyiodide, thus completing formation of the electrolyte layer.

Then, in a similar manner to the example (2a), the counter electrode was bonded to the electrolyte layer, and the solvent from the electrolyte composition solution was removed by thorough drying, thus completing preparation of a dye-sensitized solar cell that functioned as a test cell. As shown below in Table 3, this test cell was labeled example (2c)-1.

### <Preparation of a Test Cell according to Comparative Example 2-1>

The working electrode and the counter electrode used the same electrodes as those prepared for the test cells of the examples (2a), (2b) and (2c). An acetonitrile solution containing quaternary imidazolium iodide, lithium iodide, iodine, and 4-tert-butylpyridine was prepared as the electrolyte solution for forming the electrolyte.

The working electrode and the counter electrode were positioned facing one another, and the above electrolyte solution was injected into the space between the electrodes, thus forming the electrolyte layer and completing preparation of the dye-sensitized solar cell that functioned as the test cell for the comparative example 2-1.

### <Preparation of a Test Cell according to Comparative Example 2-2>

With the exception of replacing the titanium oxide slurry used in the procedure described for the examples (2a), (2b) and (2c) with a slurry containing titanium oxide nanoparticles and titanium tetraisopropoxide, the working electrode was prepared in the same manner as described in the above examples. Furthermore, the counter electrode used the same platinum coated FTO electrode substrate as that described in the examples (2a), (2b) and (2c).

Copper iodide (CuI) was used as the electrolyte for forming the electrolyte layer. Using an acetonitrile saturated solution of CuI as the electrolyte composition solution, an operation was repeated in which the electrolyte composition solution was dripped gradually onto the oxide semiconductor porous film surface of the working electrode and subsequently dried. By using this repeating operation, the CuI was able to penetrate into, and fill, the oxide semiconductor porous film. Following completion of the dripping of the CuI solution, the counter electrode described above was superposed above the working electrode and pushed down strongly onto the electrolyte layer, thus bonding the counter electrode and the electrolyte layer. The solvent from the electrolyte composition solution was then removed by thorough drying. This procedure was used to prepare a dye-sensitized solar cell that functioned as the test cell for the comparative example 2-2.

### <Photoelectric Conversion Characteristics of the Test Cells>

The photoelectric conversion characteristics of each of the prepared test cells were then measured. The initial value of the photoelectric conversion efficiency (the initial conversion efficiency) for each test cell is shown in Table 3.

In Table 3, the ratio I⁻/I₂ represents the I⁻/I₂ ratio (molar ratio of the initial constituents) in the propylene carbonate solution that was used when doping the polymer film that forms the electrolyte layer with the redox pair including iodide ion and polyiodide.

**(Table 3)**

| Number | Electrolyte component | I⁻/I₂ | State | Initial conversion efficiency (%) |
|---|---|---|---|---|
| (2a)-1 | polythiophene | 10:1 | solid | 2.5 |
| (2a)-2 | polythiophene | 4:1 | solid | 3.0 |
| (2a)-3 | polythiophene | 2:1 | solid | 2.3 |
| (2b)-1 | polypyrrole | 10:1 | solid | 2.5 |
| (2c)-1 | polyaniline | 10:1 | solid | 1.9 |
| Ref. 2-1 | acetonitrile solution | - | liquid | 5.5 |
| Ref. 2-2 | solid CuI | - | solid | 1.4 |

In the test cells from the examples (2a), (2b) and (2c), the electrolyte layer had an external appearance similar to a plastic, and tests on the state of the electrolyte confirmed the solid state.

When the measurements of the photoelectric conversion characteristics of the dye-sensitized solar cells from each of the examples (2a), (2b) and (2c) were continued, even after 3 hours, the type of marked fall in photoelectric conversion efficiency observed in the comparative example 2-1 was not seen, and the cells continued to operate well. Furthermore, problems of electrolyte leakage or solvent volatilization also did not occur.

From these results it was evident that the test cells of the examples (2a), (2b) and (2c) displayed favorable photoelectric conversion characteristics, and were able to withstand continuous usage for extended periods.

In the case of the test cell of the comparative example 2-1, the solvent of the electrolyte gradually volatilized from the point where measurement of the photoelectric conversion characteristics was commenced, and by the time 3 hours had passed, the photoelectric conversion efficiency had fallen to less than 10% of the initial value, and the cell had essentially ceased to operate as a photoelectric conversion element.

In the case of the test cell of the comparative example 2-2, there were no problems of electrolyte leakage or solvent volatilization, but the photoelectric conversion efficiency was a low 1.4% from the start of measurements. Furthermore, after 3 hours the photoelectric conversion efficiency was approximately 70% (approximately 1.0%) of the initial value. In other words, compared with the test cells of the examples (2a), (2b) and (2c), the photoelectric conversion characteristics were markedly inferior.

### <Preparation of a Test Cell according to Example (2d)>

With the exception of sealing the outside of the two electrolyte substrates with a molten polyolefm based resin after the counter electrode had been bonded to the electrolyte layer and the solvent from the electrolyte composition solution had been removed by thorough drying, a dye-sensitized solar cell was prepared using the same procedure as that described for the test cells of the above examples (2a), (2b) and (2c). The cell was labeled as example (2d).

### <Preparation of a Test Cell according to Comparative Example 2-3>

The working electrode and the counter electrode used the same electrodes as those prepared for the test cells of the examples (2a), (2b) and (2c). Furthermore, the same acetonitrile solution as that described for the test cell of the comparative example 2-1 was used as the electrolyte solution.

The working electrode and the counter electrode were positioned facing one another with a thermoplastic polyolefin based resin sheet of thickness 50 µm disposed therebetween, and by subsequently heating and melting the resin sheet, the working electrode and the counter electrode were secured together with a gap maintained therebetween. A small aperture was opened in a portion of the counter electrode to function as an injection port for the electrolyte, and the aforementioned electrolyte solution was injected in through this port to form the electrolyte layer. The injection port was then sealed with a combination of an epoxy based sealing resin and a polyolefin based resin, thus completing preparation of a dye-sensitized solar cell. This was used as the test cell for the comparative example 2-3.

### <Durability Testing of Test Cells>

One test cell from the example (2d) and one test cell of the comparative example 2-3 were placed in a thermostatic chamber at a temperature of 80°C and left for a period of 7 days. The test cells were then removed from the thermostatic chamber, and when the external appearance of each cell was inspected visually, the test cell of the comparative example 2-3 showed a deterioration in the sealing provided by the polyolefm, and a portion of the electrolyte solution had volatilized, resulting in the generation of both large and small gas bubbles. As a result, the cell essentially ceased to operate as a photoelectric conversion element.

The test cell of the example (2d) showed no obvious variations in external appearance such as gas bubble formation within the electrolyte layer.

### <Destructive Testing of Test Cells>

One test cell from the example (2d) and one test cell of the comparative example 2-3 were broken with a hammer from the glass substrate side of the cell, and when the cell was then held with the broken section facing downward, the electrolyte leaked from the test cell in the case of the comparative example 2-3. In contrast, in the test cell according to the example (2d), because the electrolyte layer was solid, no electrolyte leakage occurred.

Next, an electrolyte composition and a photoelectric conversion element according to the third aspect not according to the present invention are described with reference to the dye-sensitized solar cell of the embodiment shown in FIG. 1. The area in which the photoelectric conversion element according to the third aspect differs from the first aspect is in the nature of the electrolyte composition.

The dye-sensitized solar cell 1 shown in FIG. 1 includes a working electrode 6, including an oxide semiconductor porous film 5, formed from fine particles of an oxide semiconductor such as titanium oxide with a photosensitizing dye supported thereon, provided on top of a transparent electrode substrate 2, and a counter electrode 8 provided opposing this working electrode 6. An electrolyte layer 7 is formed between the working electrode 6 and the counter electrode 8.

The electrolyte composition that forms the electrolyte layer 7 includes, as an essential component, a polymer compound containing a cation structure, generated by the action of a halogen atom on a polymer with a partial π-conjugated structure, on either the principal chain or a side chain of the polymer, and a halide ion and/or a polyhalide as the counter anion to this cation structure.

The polymer compound may be either a single polymer compound, or a mixture of a plurality of different polymer compounds. The molecular weight for the polymer compound is within a range from several hundred to several million, and preferably from several thousand to several hundred thousand, and even more preferably in the order of several tens of thousands.

The polymer with a partial π-conjugated structure includes a plurality of unsaturated linkages such as carbon-carbon double bonds, carbon-carbon triple bonds, and carbon-nitrogen double bonds (such as -CH=N-) within the principal chain or side chains of the polymer, and these unsaturated linkages form partial π-conjugated structures within the polymer chain. The term "partial π-conjugated structure" refers to either the case where a single such unsaturated linkage exists in isolation, or cases where from 2 to 10 of such unsaturated linkages exist in a continuous chain (conjugated) with single bonds between the unsaturated linkages.

This type of polymer (an undoped polymer) generates a cation structure through doping with halogen atoms.

Specific examples of the undoped polymer include cis-1,4-polydiene based polymers as shown below in the formula (3-1), trans-1,4-polydiene based polymers as shown below in the formula (3-2), and 1,2-polydiene based polymers as shown below in the formula (3-3).

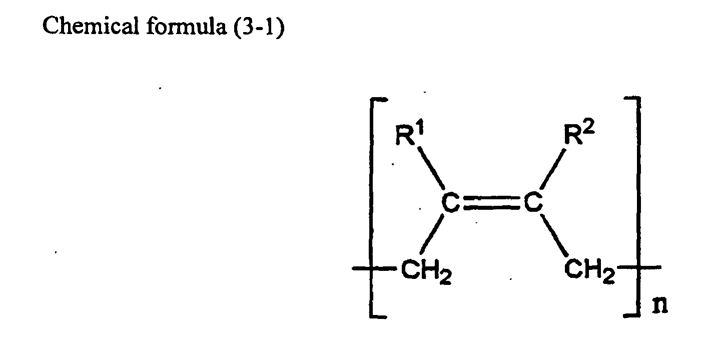

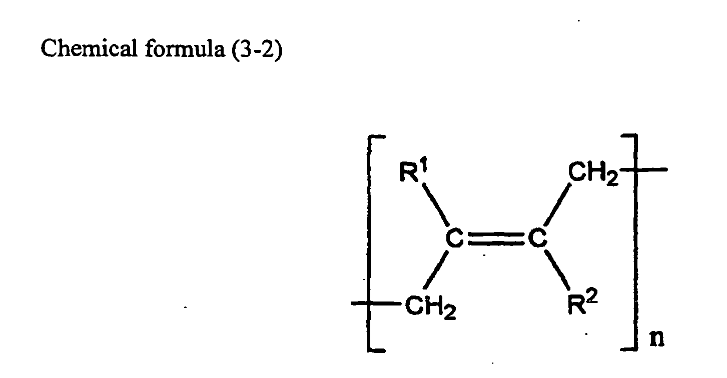

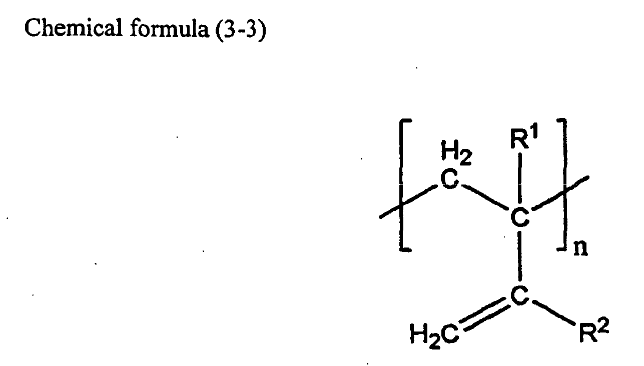

In the formulas (3-1), (3-2) and (3-3), the groups R¹ and R² can be selected independently, with each group representing a hydrogen atom; a halogen atom such as fluorine, chlorine, bromine or iodine; a cyano group; a straight chain alkyl group such as a methyl or ethyl group; or an alkoxy group such as a methoxy or ethoxy group.

In the formula (3-1), the case where R¹ and R² are both hydrogen atoms represents cis-1,4-polybutadiene, the case where R¹ is a methyl group and R² is a hydrogen atom represents cis-1,4-polyisoprene, and the case where R¹ and R² are both methyl groups represents cis-1,4-poly(2,3-dimethylbutadiene).

In the formula (3-2), the case where R¹ and R² are both hydrogen atoms represents trans-1,4-polybutadiene, the case where R¹ is a methyl group and R² is a hydrogen atom represents trans-1,4-polyisoprene, and the case where R¹ and R² are both methyl groups represents trans-1,4-poly(2,3-dimethylbutadiene).

In the formula (3-3), the case where R¹ and R² are both hydrogen atoms represents 1,2-polybutadiene, the case where R¹ is a methyl group and R² is a hydrogen atom represents 1,2-polyisoprene, the case where R¹ is a hydrogen atom and R² is a methyl group represents 3,4-polyisoprene, and the case where R¹ and R² are both methyl groups represents 1,2-poly(2,3-dimethylbutadiene).

The aforementioned undoped polymer can be produced by polymerization of a known monomer such as butadiene or isoprene, using an appropriate polymerization method. Furthermore, commercially available polymers can also be used, although of course the present invention is not restricted to such cases. Furthermore, copolymers with styrene, acrylonitrile or isobutene can also be formed.

The undoped polymer is partially oxidized by the addition of a dopant such as a halogen, thus forming a polymer compound with a cation structure (namely, a cationic polymer). Examples of possible counter anions for the cationic polymer include halide ions such as iodide ions, bromide ions and chloride ions; and polyhalide ions such as Br3⁻, I₃⁻, I₅⁻, I₇⁻, Cl₂I⁻, ClI₂⁻, Br₂I⁻ and BrI2⁻.

Polyhalide ions are anions including a plurality of halogen atoms, and can be obtained by reacting a halide ion such as Cl⁻, Br or I⁻ with a halogen molecule. This halogen molecule can use either simple halogen molecules such as Cl₂, Br₂ and I₂, and/or interhalogen compounds such as ClI, BrI and BrCl.

Although addition of halogen molecules is not essential, such halogen molecule addition is preferred. In those cases where halogen molecules are added to form polyhalide ions, the halide ion and the polyhalide ion form a redox pair, enabling an improvement in the photoelectric conversion characteristics. There are no particular restrictions on the ratio of the halogen molecules to the halide ions, and molar ratios from 0% to 100% are preferred.

In conventional gel-like electrolyte compositions where a liquid electrolyte is gelled and solidified, the polymer performs the role of the curing agent for curing the liquid electrolyte.

In contrast, in an electrolyte composition of the present invention, the polymer compound described above displays conductivity itself, performs an important role in charge transfer in an electrolyte composition containing a redox pair, and is a solid.

A variety of additives such as ionic liquids; organic nitrogen compounds such as 4-tert-butylpyridine, 2-vinylpyridine and N-vinyl-2-pyrrolidone; and other additives such as lithium salts, sodium salts, magnesium salts, iodide salts, thiocyanates and water can be added to the electrolyte composition of the present invention if required, provided such addition does not impair the properties and characteristics of the electrolyte composition. Examples of the aforementioned ionic liquids include salts that are liquid at room temperature, and include a cation such as a quaternary imidazolium, quaternary pyridinium or quaternary ammonium ion, and an anion such as an iodide ion, a bis-trifluoromethylsulfonylimide anion, a hexafluorophosphate ion (PF₆) or a tetrafluoroborate ion (BF₄⁻).

In those cases where the composition incorporates a plasticizer (a liquid component), the proportion of the plasticizer is preferably no more than 50%, and even more preferably no more than 10%, of the weight of the composition.

The transparent electrode substrate 2 includes a conductive layer 3 formed from a conductive material, formed on top of a transparent base material 4 such as a glass plate or a plastic sheet.

The material for the transparent base material 4 preferably displays a high level of light transmittance during actual application, and suitable examples include glass, transparent plastic sheets such as polyethylene terephthalate (PET), polyethylene naphthalate (PEN), polycarbonate (PC) and polyethersulfone (PES), and polished sheets of ceramics such as titanium oxide and alumina.

From the viewpoint of achieving a favorable light transmittance for the transparent electrode substrate 2, the conductive layer 3 is preferably formed from either a single transparent oxide semiconductor such as tin-doped indium oxide (ITO), tin oxide (SnO₂) or fluorine-doped tin oxide (FTO), or a composite of a plurality of such oxides. However, the present invention is not restricted to such configurations, and any material that is appropriate for the targeted use in terms of light transmittance and conductivity can be used. Furthermore, in order to improve the collection efficiency of the oxide semiconductor porous film 5 and the electrolyte layer 7, a metal wiring layer formed from gold, silver, platinum, aluminum, nickel or titanium or the like can also be used, provided the proportion of the surface area covered by the metal wiring layer does not significantly impair the light transmittance of the transparent electrode substrate 2. In those cases where a metal wiring layer is used, the layer is preferably formed with a lattice-type pattern, a striped pattern, or a comb-type pattern or the like, so that as far as possible, light can pass uniformly through the transparent electrode substrate 2.

Formation of the conductive layer 3 can be conducted using a known method that is appropriate for the material used as the conductive layer 3. For example, formation of a conductive layer 3 from an oxide semiconductor such as ITO can be achieved using a thin film formation method such as sputtering, a CVD method or a SPD (spray pyrolysis deposition) method. Taking the light transmittance and conductivity into consideration, the layer is normally formed with a film thickness of 0.05 to 2.0 µm.

The oxide semiconductor porous film 5 is a porous thin film of thickness 0.5 to 50 µm including, as a main component, fine particles of an oxide semiconductor with an average particle size of 1 to 1000 nm, formed from either a single material such as titanium oxide (TiO₂), tin oxide (SnO₂), tungsten oxide (WO₃), zinc oxide (ZnO) or niobium oxide (Nb₂O₅), or a composite material of two or more such oxides.

Formation of the oxide semiconductor porous film 5 can be achieved by first forming either a dispersion prepared by dispersing commercially available fine particles of the oxide semiconductor in a suitable dispersion medium, or a colloid solution prepared using a sol-gel method, adding appropriate additives as desired, and then applying the dispersion or solution using a conventional method such as screen printing, ink-jet printing, roll coating, a doctor blade method, spin coating, or a spray application method. Other methods can also be used, including electrophoretic deposition methods in which the electrode substrate 2 is immersed in the aforementioned colloid solution, and electrophoresis is used to deposit fine particles of the oxide semiconductor onto the electrode substrate 2, methods in which a foaming agent is mixed with the above colloid solution or dispersion, which is then applied and sintered to generate a porous material, and methods in which polymer micro beads are mixed with the above colloid solution or dispersion prior to application, and following application these polymer micro beads are removed by either heat treatment or a chemical treatment, thus forming voids and generating a porous material.

There are no particular restrictions on the sensitizing dye supported on the oxide semiconductor porous film 5, and suitable examples include bipyridine structures, ruthenium complexes or iron complexes with ligands containing a terpyridine structure, metal complexes of porphyrin systems and phthalocyanine systems, and organic dyes such as eocene, rhodamine, merocyanine and coumarin. One or more of these compounds can be appropriately selected in accordance with the target application and the material of the oxide semiconductor porous film being used.

The counter electrode 8 can use an electrode produced by forming a thin film of a conductive oxide semiconductor such as ITO or FTO on a substrate formed from a nonconductive material such as glass, or an electrode in which a conductive material such as gold, platinum or a carbon based material is deposited on the surface of a substrate by either vapor deposition or application or the like. Electrodes in which a layer of platinum or carbon or the like is formed on a thin film of a conductive oxide semiconductor such as ITO or FTO can also be used.

One example of a method for preparing the counter electrode 8 is a method in which a platinum layer is formed by applying chloroplatinic acid and then conducting a heat treatment. Alternatively, methods in which the electrode is formed on the substrate using either vapor deposition or sputtering can also be used.

An example of a method of forming the electrolyte layer 7 on top of the working electrode 6 is a method in which an electrolyte composition solution is first prepared by mixing the aforementioned polymer compound with a suitable organic solvent, adding halogen molecules and additives as necessary, and then stirring the mixture to dissolve all of the components uniformly, and subsequently, an operation in which this prepared electrolyte composition solution is dripped gradually onto the working electrode 6 and subsequently dried is repeated to form the electrolyte layer 7. By using this method, when the electrolyte composition is cast onto the working electrode 6, the electrolyte composition solution can penetrate favorably into, and fill, the voids in the oxide semiconductor porous film 5.

Suitable examples of the above organic solvent used for dissolving the polymer compound include acetonitrile, methoxyacetonitrile, propionitrile, propylene carbonate, diethyl carbonate, methanol, γ-butyrolactone, and N-methylpyrrolidone. The aforementioned polymer compound preferably displays a good level of solubility in at least one of these organic solvents.

Because the electrolyte composition of the present invention exists in a solid state, volatility and fluidity are poor, meaning when the electrolyte composition is used in a photoelectric conversion element such as a dye-sensitized solar cell, deterioration or loss of the electrolyte through solvent volatilization or the like does not occur, the output level and the photoelectric conversion characteristics are excellent, and the cell is able to function stably over extended periods. Furthermore, leakage of the electrolyte through gaps in the container, or scattering of the electrolyte caused by damage to the element can also be suppressed, resulting in excellent handling properties.

The definition of a solid state in the present invention can be easily determined using the following test. First, as shown in FIG. 2A, adhesive tape 13 is stuck to one surface of an approximately 5 cm square glass plate 11, leaving a central section 12 of approximately 20 mm square, and an electrolyte composition solution is then dripped onto the central section 12 enclosed by the adhesive tape 13. After drying, the adhesive tape 13 is peeled off, generating a glass plate 11 with an electrolyte film 14 formed thereon. The film thickness of the electrolyte film 14 is approximately 30 µm. Subsequently, as shown in FIG. 2B, the glass plate 11 is stood up perpendicular to the floor surface 15, and is left to stand at room temperature for 10 hours. After 10 hours, if the electrolyte film 14 has not contacted the floor surface 15, then the fluidity of the electrolyte composition is very low, and the composition is deemed to be a solid. In contrast, if the electrolyte film 14 has contacted the floor surface 15, then the fluidity of the electrolyte composition is high, and the composition is deemed a liquid.

As follows is an even more detailed description of an electrolyte composition and photoelectric conversion element according to the third aspect, based on a series of examples.

### <Preparation of Test Cells according to Example (3a) (not according to the invention)>

Using a glass plate with an attached FTO film as the transparent electrode substrate, a slurry-like aqueous dispersion of titanium dioxide with an average particle size of 20 nm was applied to the FTO film (the conductive layer) side of the transparent electrode substrate 2, and following drying, the applied layer was subjected to heat treatment at 450°C for 1 hour, thus forming an oxide semiconductor porous film of thickness 7 µm. The substrate was then immersed overnight in an ethanol solution of a ruthenium bipyridine complex (N3 dye), thus supporting the dye in the porous film and forming the working electrode. Furthermore, an FTO glass electrode substrate with an electrode layer of platinum formed thereon by sputtering was also prepared as the counter electrode.

Subsequently, an electrolyte layer was formed on the working electrode using the method described below.

First, a tetrahydrofuran solution was prepared containing polybutadiene as the polydiene based polymer, NaI, and I₂.

An operation was then repeated in which this tetrahydrofuran solution was dripped gradually onto the oxide semiconductor porous film surface of the working electrode and subsequently dried. By using this repeating operation, the electrolyte composition was able to penetrate into, and fill, the oxide semiconductor porous film. Following completion of the dripping of the electrolyte composition solution, while the electrolyte was still in a half dried state, the counter electrode described above was superposed above the working electrode and pushed down strongly onto the electrolyte layer, thus bonding the counter electrode and the electrolyte layer. The solvent from the electrolyte composition solution was then removed by thorough drying. The procedure described above was used to prepare dye-sensitized solar cells that functioned as test cells. As shown below in Table 4, these test cells were labeled example (3a)-1through (3a)-3.

### <Preparation of Test Cells according to Example (3b) (not according to the invention)>

The examples (3b) differ from the examples (2a) in that polyisoprene is used as the polydiene based polymer. The remaining construction of the test cells is the same as that of the examples (3a), and consequently the description is omitted here.

Dye-sensitized solar cells that functioned as test cells were prepared in the same manner as the examples (3a). As shown in Table 4, these test cells were labeled example (3b)-1 to (3b)-2.

### <Preparation of a Test Cell according to Comparative Example 3-1>

The working electrode and the counter electrode used the same electrodes as those prepared for the test cells of the above examples (3a) and (3b). An acetonitrile solution containing quaternary imidazolium iodide, lithium iodide, iodine, and 4-tert-butylpyridine was prepared as the electrolyte solution for forming the electrolyte.

The working electrode and the counter electrode were positioned facing one another, and the above electrolyte solution was injected into the space between the electrodes, thus forming the electrolyte layer and completing preparation of the dye-sensitized solar cell that functioned as the test cell for the comparative example 3-1.

### <Preparation of a Test Cell according to Comparative Example 3-2>

With the exception of replacing the titanium oxide slurry used in the procedure described for the examples (3a) and (3b) with a slurry containing titanium oxide nanoparticles and titanium tetraisopropoxide, the working electrode was prepared in the same manner as described in the above examples. Furthermore, the counter electrode used the same platinum coated FTO electrode substrate as that described in the examples (3a) and (3b).

Copper iodide (CuI) was used as the electrolyte for forming the electrolyte layer. - Using an acetonitrile saturated solution of CuI as the electrolyte composition solution, an operation was repeated in which the electrolyte composition solution was dripped gradually onto the oxide semiconductor porous film surface of the working electrode and subsequently dried. By using this repeating operation, the CuI was able to penetrate into, and fill, the oxide semiconductor porous film. Following completion of the dripping of the CuI solution, the counter electrode described above was superposed above the working electrode and pushed down strongly onto the electrolyte layer, thus bonding the counter electrode and the electrolyte layer. The solvent from the electrolyte composition solution was then removed by thorough drying. This procedure was used to prepare a dye-sensitized solar cell that functioned as the test cell for the comparative example 3-2.

### <Photoelectric Conversion Characteristics of the Test Cells>

The photoelectric conversion characteristics of each of the prepared test cells were then measured. The initial value of the photoelectric conversion efficiency (the initial conversion efficiency) for each test cell is shown in Table 4.

**(Table 4) (not according to the invention)**

| Number | Electrolyte component | I⁻/I₂ | State | Initial conversion efficiency (%) |
|---|---|---|---|---|
| (3a)-1 | polybutadiene | 10:1 | solid | 3.1 |
| (3a)-2 | polybutadiene | 4:1 | solid | 3.2 |
| (3a)-3 | polybutadiene | 1.5:1 | solid | 2.4 |
| (3b)-1 | polyisoprene | 10:1 | solid | 2.4 |
| (3b)-2 | polyisoprene | 1.5:1 | solid | 2.5 |
| Ref. 3-1 | acetonitrile solution | - | liquid | 5.5 |
| Ref. 3-2 | solid CuI | - | solid | 1.4 |

In the test cells from the examples (3a) and (3b), the electrolyte layer had an external appearance similar to a plastic, and tests on the state of the electrolyte confirmed the solid state.

When the measurements of the photoelectric conversion characteristics of the dye-sensitized solar cells from each of the examples (3a) and (3b) were continued, even after 3 hours, the type of marked fall in photoelectric conversion efficiency observed in the comparative example 3-1 was not seen, and the cells continued to operate well. Furthermore, problems of electrolyte leakage or solvent volatilization also did not occur.

From these results it was evident that the test cells of the examples (3a) and (3b) displayed very favorable photoelectric conversion characteristics, and were able to withstand continuous usage for extended periods.

In the case of the test cell of the comparative example 3-1, the solvent of the electrolyte gradually volatilized from the point where measurement of the photoelectric conversion characteristics was commenced, and by the time 3 hours had passed, the photoelectric conversion efficiency had fallen to less than 10% of the initial value, and the cell had essentially ceased to operate as a photoelectric conversion element.

In the case of the test cell of the comparative example 3-2, there were no problems of electrolyte leakage or solvent volatilization, but the photoelectric conversion efficiency was a low 1.4% from the start of measurements. Furthermore, after 3 hours the photoelectric conversion efficiency was approximately 70% (approximately 1.0%) of the initial value. In other words, compared with the test cells of the examples (3a) and (3b), the photoelectric conversion characteristics were markedly inferior.

### <Preparation of a Test Cell according to Example (3c) (not according to the invention)>

With the exception of sealing the outside of the two electrolyte substrates with a molten polyolefin based resin after the counter electrode had been bonded to the electrolyte layer and the solvent from the electrolyte composition solution had been removed by thorough drying, a dye-sensitized solar cell was prepared using the same procedure as that described for the test cells of the above examples (3a) and (3b). The cell was labeled as example (3c).

### <Preparation of a Test Cell according to Comparative Example 3-3>

The working electrode and the counter electrode used the same electrodes as those prepared for the test cells of the examples (3a) and (3b). Furthermore, the same acetonitrile solution as that described for the test cell of the comparative example 3-1 was used as the electrolyte solution.

The working electrode and the counter electrode were positioned facing one another with a thermoplastic polyolefin based resin sheet of thickness 50 µm disposed therebetween, and by subsequently heating and melting the resin sheet, the working electrode and the counter electrode were secured together with a gap maintained therebetween. A small aperture was opened in a portion of the counter electrode to function as an injection port for the electrolyte, and the aforementioned electrolyte solution was injected in through this port to form the electrolyte layer. The injection port was then sealed with a combination of an epoxy based sealing resin and a polyolefin based resin, thus completing preparation of a dye-sensitized solar cell. This was used as the test cell for the comparative example 3-3.

### <Durability Testing of Test Cells>

One test cell from the example (3c) and one test cell of the comparative example 3-3 were placed in a thermostatic chamber at a temperature of 80°C and left for a period of 7 days. The test cells were then removed from the thermostatic chamber, and when the external appearance of each cell was inspected visually, the test cell of the comparative example 3-3 showed a deterioration in the sealing provided by the polyolefin, and a portion of the electrolyte solution had volatilized, resulting in the generation of both large and small gas bubbles. As a result, the cell essentially ceased to operate as a photoelectric conversion element.

The test cell of the example (3c) showed no obvious variations in external appearance such as gas bubble formation within the electrolyte layer.

### <Destructive Testing of Test Cells>

One test cell from the example (3c) and one test cell of the comparative example 3-3 were broken with a hammer from the glass substrate side of the cell, and when the cell was then held with the broken section facing downward, the electrolyte leaked from the test cell in the case of the comparative example 3-3. In contrast, in the test cell according to the example (3c), because the electrolyte layer was solid, no electrolyte leakage occurred.

### INDUSTRIAL APPLICABILITY

An electrolyte composition of the present invention can be used for the electrolyte layer in a photoelectric conversion element such as a dye-sensitized solar cell.

## Claims

1. An electrolyte composition, which is in solid form, and comprises a polymer compound containing: a cation structure formed by partial oxidation of a π-conjugated polymer as a principal chain of said polymer,
**characterized in that** said polymer compound comprises both a halide ion and a polyhalide as counter anions, and
said halide ion and said polyhalide form a redox pair.

2. An electrolyte composition according to claim 1,
wherein said halide ion or said polyhalide is an iodine based anion.

3. An electrolyte composition according to claim 1,
wherein said redox pair formed from said halide ion and said polyhalide is I⁻/I₃⁻.

4. A photoelectric conversion element,
which uses an electrolyte composition according to claim 1 as an electrolyte.

5. A photoelectric conversion element according to claim 4,
which is a dye-sensitized solar cell, comprising a working electrode, which comprises an oxide semiconductor porous film with a dye supported thereon formed on an electrode substrate, and a counter electrode disposed opposing said working electrode, wherein
an electrolyte layer formed from an electrolyte composition according to claim 1 is provided between said working electrode and said counter electrode.

## Patentansprüche

1. Elektrolytische Zusammensetzung, die in solider Form ist und einen Polymerverbund umfasst, der eine durch Teiloxidation eines pi-konjugierten Polymers als eine Hauptkette dieses Polymers gebildete Kationenstruktur enthält, **dadurch gekennzeichnet, dass** der Polymerverbund sowohl ein Halogenidion als auch ein Polyhalogenid als Gegenanionen enthält, und dass das Halogenidion und das Polyhalogenid ein Redoxpaar ausbilden.

2. Elektrolytische Zusammensetzung gemäß Anspruch 1,
wobei das Halogenidion oder das Polyhalogenid ein jodhaltiges Anion ist.

3. Elektrolytische Zusammensetzung gemäß Anspruch 1,
wobei das durch das Halogenidion und das Polyhalogenid ausgebildete Redoxpaar I⁻/I₃⁻ ist.

4. Photoelektrisches Konvertierungselement,
das eine elektrolytische Zusammensetzung gemäß Anspruch 1 als einen Elektrolyt anwendet.

5. Photoelektrisches Konvertierungselement gemäß Anspruch 4,
die eine Farbstoff-Solarzelle ist, umfassend eine Arbeitselektrode, die einen porösen halbleitenden Oxidfilm mit einer auf diesem getragenen Farbe enthält, der an einem Elektrodensubstrat gebildet ist, und eine der gesagten Arbeitselektrode entgegengesetzte Gegenelektrode, wobei eine aus einer elektrolytischer Zusammensetzung gemäß Anspruch 1 ausgebildet elektrolytische Schicht zwischen dieser Arbeitselektrode und der Gegenelektrode angeordnet ist.

## Revendications

1. Composition électrolytique, sous forme solide et comprenant un composé polymère contenant une structure cationique formée par oxydation partielle d'un polymère pi-conjugué comme chaîne principale de ce polymère, **caractérisée en ce que** le composé polymère comprend un ion halogénure de même qu'un polyhalogénure comme contre-anions, et **en ce que** l'ion halogénure et que le polyhalogénure constituent une paire redox.

2. Composition électrolytique selon la revendication 1,
dans laquelle l'ion halogénure ou le polyhalogénure est un anion à base d'iode.

3. Composition électrolytique selon la revendication 1,
dans laquelle la paire redox constituée du ion halogénure et du polyhalogénure est I⁻/I⁻3.

4. Elément de conversion photoélectrique utilisant une composition électrolytique selon la revendication 1 comme électrolyte.

5. Elément de conversion photoélectrique selon la revendication 4,
constituée d'une cellule solaire sensibilisée par colorant, comprenant une électrode de travail, contenant un film d'oxyde semi-conducteur poreux présentant un colorant, formé sur un substrat d'électrode, et une contre-électrode opposée à ladite électrode de travail, dans laquelle une couche électrolytique constituée d'une composition électrolytique selon la revendication 1 est disposée entre ladite électrode de travail et ladite contre-électrode.
